# EUROPEAN PATENT APPLICATION

(11) **EP 4 614 335 A1**
(43) Date of publication of application: **10.09.2025**
(21) Application number: 25155402.8
(22) Date of filing: 31.01.2025
(51) Int. Cl.: G06F 13/38, G06F 13/40, G06F 13/42, H03M 7/30, H04L 69/04, H04L 69/22, H03M 7/40, H03M 7/42

(54) **APPARATUS AND METHOD FOR SCENARIO-BASED COMPRESSION IN A PROCESSOR**

(30) Priority: 08.03.2024 US 202418600611
(71) Applicant: INTEL Corporation, Santa Clara, CA 95054 (US)
(72) Inventor: DIAMAND, Israel, 99850 Aderet (IL)
(74) Representative: HGF

(57) **Abstract**

Techniques for scenario-based compression, including a processor (100), comprising: a first die (102) of a plurality of dies coupled over a first inter-die link (106) to a second die (104), the first die (102) comprising: message control registers to store message fields; message compression circuitry to compress a message transmitted over the first inter-die link (106), the first message compression circuitry to replace a message field in the message with an indication of a storage location of the message field in the first one or more message control registers; the second die (104) comprising: second message control registers to store the message fields; message decompression circuitry to decompress the message received over the first inter-die link (106) from the first die (102), the message decompression circuitry to identify the storage location of the message field in the second one or more message control registers based on the indication and to insert the message field in the message.

## Description

### TECHNICAL FIELD

The disclosure relates generally to computer systems. More specifically, an embodiment of the disclosure relates to an apparatus and method for scenario-based compression in a processor.

### BACKGROUND

A processor, or set of processors, executes instructions from an instruction set, e.g., the instruction set architecture (ISA). The instruction set is the part of the computer architecture related to programming, and generally includes the native data types, instructions, register architecture, addressing modes, memory architecture, interrupt and exception handling, and external input and output (I/O).

### BRIEF DESCRIPTION OF THE DRAWINGS

The present disclosure is illustrated by way of example and not limitation in the figures of the accompanying drawings, in which like references indicate similar elements and in which:
**Figure 1** illustrates a hardware processor according to embodiments of the disclosure.
**Figure 2A** illustrates a hardware processor according to embodiments of the disclosure.
**Figure 2B** illustrates a hardware processor according to embodiments of the disclosure.
**Figure 3** illustrates a hardware processor according to embodiments of the disclosure.
**Figure 4** illustrates a transmitter circuit of a first die coupled to a receiver circuit of a second die through an interconnect according to embodiments of the disclosure.
**Figure 5** illustrates a data timing diagram and a clock timing diagram for a first clocking rate according to embodiments of the disclosure.
**Figure 6** illustrates a data timing diagram and a clock timing diagram for a second clocking rate according to embodiments of the disclosure.
**Figure 7** illustrates a transmitter circuit of a first die coupled to a receiver circuit of a second die through an interconnect according to embodiments of the disclosure.
**Figure 8** illustrates a data timing diagram and a clock timing diagram for a first clocking rate according to embodiments of the disclosure.
**Figure 9** illustrates a data timing diagram and a clock timing diagram for a second clocking rate according to embodiments of the disclosure.
**Figure 10** illustrates a hardware processor according to embodiments of the disclosure.
**Figure 11** illustrates a hardware processor according to embodiments of the disclosure.
**Figure 12** illustrates a hardware processor according to embodiments of the disclosure.
**Figures 13A-B** illustrate an example embodiment with interconnections between different dies/fabrics.
**Figure 14** illustrates a method for compressing a message in accordance with some embodiments of the invention.
**Figure 15** illustrates a method for decompressing a message in accordance with some embodiments of the invention.
**Figure 16** illustrates a sequence of transactions in accordance with one embodiment.
**Figure 17** illustrates compression circuitry in accordance with some embodiments.
**Figure 18** illustrates decompression circuitry in accordance with some embodiments.
**Figure 19A** is a block diagram illustrating both an exemplary in-order pipeline and an exemplary register renaming, out-of-order issue/execution pipeline according to embodiments of the disclosure.
**Figure 19B** is a block diagram illustrating both an exemplary embodiment of an in-order architecture core and an exemplary register renaming, out-of-order issue/execution architecture core to be included in a processor according to embodiments of the disclosure.
**Figure 20A** is a block diagram of a single processor core, along with its connection to the on-die interconnect network and with its local subset of the Level 2 (L2) cache, according to embodiments of the disclosure.
**Figure 20B** is an expanded view of part of the processor core in **Figure 20A** according to embodiments of the disclosure.
**Figure 21** is a block diagram of a processor that may have more than one core, may have an integrated memory controller, and may have integrated graphics according to embodiments of the disclosure.
**Figure 22** is a block diagram of a system in accordance with one embodiment of the present disclosure.
**Figure 23** is a block diagram of a more specific exemplary system in accordance with an embodiment of the present disclosure
**Figure 24** is a block diagram of a second more specific exemplary system in accordance with an embodiment of the present disclosure.
**Figure 25****,** shown is a block diagram of a system on a chip (SoC) in accordance with an embodiment of the present disclosure.
**Figure 26** is a block diagram contrasting the use of a software instruction converter to convert binary instructions in a source instruction set to binary instructions in a target instruction set according to embodiments of the disclosure.

### DETAILED DESCRIPTION

In the following description, numerous specific details are set forth. However, it is understood that embodiments of the disclosure may be practiced without these specific details. In other instances, well-known circuits, structures and techniques have not been shown in detail in order not to obscure the understanding of this description.

References in the specification to "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

A (e.g., hardware) processor, or set of processors, executes instructions from an instruction set, e.g., the instruction set architecture (ISA). The instruction set is the part of the computer architecture related to programming, and generally includes the native data types, instructions, register architecture, addressing modes, memory architecture, interrupt and exception handling, and external input and output (I/O). It should be noted that the term instruction herein may refer to a macro-instruction, e.g., an instruction that is provided to the processor for execution, or to a micro-instruction, e.g., an instruction that results from a processor's decode unit (decoder) decoding macro-instructions. A processor (e.g., having one or more cores to decode and/or execute instructions) may operate on data, for example, in performing arithmetic, logic, or other functions.

A processor may be formed on a single die, e.g., a single (semiconductor) block of integrated circuits. In one embodiment, a single die may have (e.g., manufacturing) errors or defects that impede or remove certain functionality of the die. This liability to process defect may increase with the die area, as does the fabrication investment at risk of loss in construction of (e.g., large) processors. A processor may be formed on a single die (e.g., fabrication) having all hardware functionality at one design release, e.g., and not have hardware supported features added, enhanced, or optimized where those new capabilities were not in the original design release.

Certain embodiments herein provide for multiple physically separate (e.g., discrete) dies to be (e.g., electrically) connected together by an interconnect to form a processor. Certain embodiments herein provide for a single (e.g., monolithic) cache coherency domain over that interconnect. Certain embodiments herein include not packetizing and/or not serializing the data (e.g., transmitted and/or received) over an interconnect (e.g., between dies). Certain embodiments herein reduce the risk associated with a single (e.g., large) die size. Certain embodiments herein allow for the forming of a processor from the same (and/or a mirrored version of a) die duplicated multiple times to create a (e.g., larger) monolithic domain. Certain embodiments herein allow redundancy for yield recovery and/or die testability. For example, different dies and/or different groupings of dies may allow a wide variety of unique processors (e.g., SKUs) with minimal or without re-design efforts. Certain embodiments herein allow a late decision on design cycle whether to manufacture a monolithic design of a die or multiple dies (e.g., a 2 way or 4 way split of the single die). Certain interconnects herein include a transparent queue to cross clock and/or power domains, for example, that may be tuned post silicon. In certain embodiments, an interconnect (e.g., with transparent queue) may have no latency impact, e.g., if both domain are running at the same frequency but running on different power sources. In certain embodiments, a transceiver circuit (e.g., a transmitter circuit and a receiver circuit) includes a transparent queue on both transmitter and receiver circuits, for example, where data is crossing a physical die boundary, e.g., crossing a power domain where each die has a different power source.

Certain embodiments herein provide a monolithic cache domain across multiple dies (e.g., allowing very large cross bandwidth but also having minimal latency and power impact). Certain embodiments herein allow a scale up in two dimensions (e.g., X-Y) and/or three dimensions (e.g., X-Y-Z). Certain embodiments herein provide for a larger die to connect to smaller die (e.g., multiple dies having a different number of physical connections on their die). Certain embodiments herein allow transportation according to multiple (e.g., any) protocols between dies (e.g., not restricted to a single protocol). Certain embodiments herein provide for a mesh loopback (e.g., micro) architecture, e.g., to tolerate die to die differences. Certain embodiments herein add an entry into a look-up table (LUT) to indicate if data (e.g., a cache line) is to cross a physical die boundary, e.g., to pass through an interconnect between two die. Certain embodiments herein allow for independent (e.g., power and/or cache) domains as needed, e.g., to help yield recovery by disabling row and/or column of an (e.g., mesh) interconnect. Certain embodiments herein allow for one die to run at a different frequency than another die of that hardware processor. Certain transport protocols herein enable a high speed interconnect between multiple dies and/or seamless crossing of the die boundaries. Alternatively to using those protocols as die to die connection, certain embodiments herein may use other solutions, e.g., utilizing an interposer.

Certain embodiments of an interconnect between multiple dies provides one or more of: (e.g., very high) increased bandwidth (BW), reduced pin count but allowing full cross sectional BW, ¼ pins used with 4x frequency of a die, ½ pins used with dynamic 1x/2x modes, for example, 1x: half BW (e.g., operating frequency matching the die, since ½ pin, ½ BW) with low power and/or latency impact, no packetization (e.g., for any die to die connection) for minimal latency impact, lower frequency and/or lower error rate (e.g., an error rate similar or less than the error rate on silicon) (e.g., to allow no error protection utilized on a between dies interconnect link or error protection for an on die interconnect utilized on a between dies interconnect link), and, for example, 2x: full BW full performance with increased power and/or latency, double the operating frequency versus die frequency, and algorithm(s) for switching between the two modes. Certain embodiments herein of an interconnect between multiple dies provides decreased latency and/or increased BW of the interconnect, e.g., much less than current die to die interconnect technology and/or equal or substantially equal to an on die interconnect.

Certain embodiments herein provide sharing processor primary resources over a high bandwidth and low-latency electrical interconnect such that the performance in accessing remote die resources is substantially similar or very near the performance of a monolithically fabricated integrated die. Certain embodiments herein provide sharing processor infrastructure resources to enable intimate management of power, thermal, clocking, reset, configuration, error handling, etc. with an electrical interconnect such that the performance in accessing remote die resources is substantially similar or very near the performance of a monolithically fabricated integrated die. Certain embodiments herein reduce the fabrication yield risk associated with a single large die size. Certain embodiments herein allow scaling to (e.g., larger) numbers of functional logic circuit components to offer redundancy for yield recovery and/or special uses such as die testability. Certain embodiments herein allow a late (e.g., or any time) decision on design cycle whether to manufacture a monolithic design of a die or multiple dies (e.g., a 2 way or 4 way split of the single die).

Certain embodiments herein allow combinations of dissimilar dies to enable staging over time design completion for some dies or for some dies to be manufactured in more matured or special fabrication process, as well as better monetizing some older dies from previous products. Certain embodiments herein allow combinations of dissimilar dies and/or quantities of dies to enable a wide variety of unique processors products (e.g., SKUs) with minimal or without re-design efforts.

Certain embodiments herein provide for a larger die to connect to smaller die and/or multiple dies having a different number of physical connections on their die. Certain embodiments herein allow for the forming of a processor from the same and/or a mirrored version of a die duplicated multiple times to create a larger monolithic domain. Certain embodiments herein allow a scale up in two dimensions (e.g., X and Y axes in Cartesian coordinates) and/or three dimensions (e.g., X, Y, and Z axes in Cartesian coordinates).

Certain embodiments herein provide circuitry (e.g., PHY) to deliver a low-latency high-bandwidth die-to-die coherent connection, e.g., substantially similar to the monolithic experience. Certain embodiments herein provide for performance neutrality and power saving capabilities equivalency to the monolithic case. Certain embodiments herein provide for the cohesive flow of individual dies in wafers into packaged modular die products. Certain embodiments herein provide for modularity and extensibility of tiling several modular dies (e.g., heterogeneous modular dies). Certain embodiments herein allow dies to influence each other seamlessly and unencumbered with security protection despite die exposure of private sideband messaging between them.

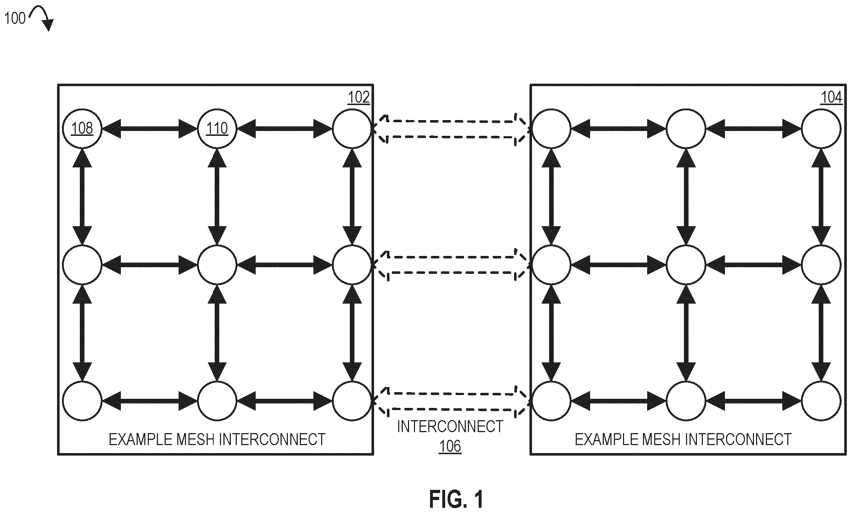

**Figure 1** illustrates a hardware processor 100 according to embodiments of the disclosure. Although not depicted, certain circuity (e.g., decode unit(s), execution unit(s), core(s), cache coherency circuitry, cache(s), or other components) may be utilized, for example, as discussed below. In one embodiment, the processor components on a single die 102 may be coupled together via an interconnect, such as the mesh interconnects illustrated in Figure 1. For example, die 102 may include component 108 and component 110 that communicate with each other through the mesh interconnect. In one embodiment, physically separate die 102 is to communicate with physically separate die 104 through interconnect 106. Die and/or interconnect may include a transceiver to transmit data between die 102 and die 104. Note that a single headed arrow herein may not require one-way communication, for example, it may indicate two-way communication (e.g., to and from that component). Any or all combinations of communications paths may be utilized in certain embodiments herein.

In one embodiment, each of die 102 and die 104 are identical. In another embodiment, die 104 is a mirror image of die 102. In one embodiment, die 102 and die 104 are different, for example, each representing a portion of a single die design that has been cleaved into multiple physical dies that are then joined together (e.g., electrically coupled) via an interconnect.

In one embodiment, a mesh interconnect of a die does not depend on a connection to another die to function, for example, the data signals (e.g., requests and/or answers) may loop back into that die, e.g., if interconnect 106 is not functioning or present. In one embodiment, such data signals are not blocking signals (e.g., not fences).

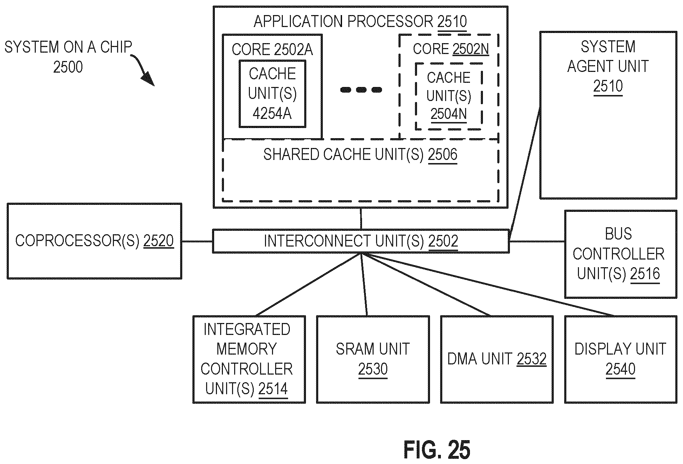

Cache coherency circuitry in each of the plurality of physically separate dies may be switchable between a master mode and a slave mode. In one embodiment, a management circuit (e.g., a controller) is to set one of the cache coherency circuits in each of the plurality of physically separate dies as master, e.g., and the rest as slave to the master. Cache coherency circuitry may be within a controller, e.g., controller(s) in Figures 25-28.

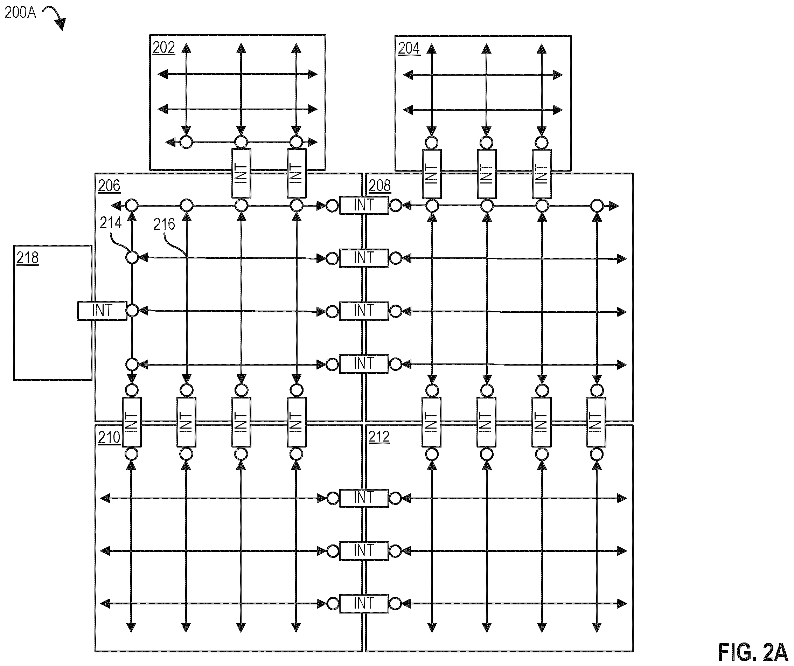

**Figure 2A** illustrates a hardware processor 200A according to embodiments of the disclosure. In the depicted embodiment, die 202 and 204 are smaller than die 206, die 208, die 210, and die 212. Each of the depicted dies is coupled to an adjacent die via an interconnect (INT). Die 202 is depicted as having two connections (e.g., discrete interconnects) with die 206. Die 204 is depicted as having a different number of (e.g., three) connections (e.g., discrete interconnects) with die 208. Die 206 is depicted as having four connections (e.g., discrete interconnects) with die 208. Die 210 is depicted as having a different number of (e.g., three) connections (e.g., discrete interconnects) with die 212.

The intersection of mesh interconnect of a die (e.g., intersection 214 or intersection 216 of die 206) may be the access point into the mesh interconnect, e.g., by a circuit component. In one embodiment, multiple (e.g., any) mesh configurations with different sizes on their respective die are coupled together by certain embodiments herein. In one embodiment, a die with a mesh interconnect is coupled to a die without a mesh interconnect, for example, die 218 is depicted in Figure 2A as coupled to mesh interconnect of die 206 though single interconnect (INT).

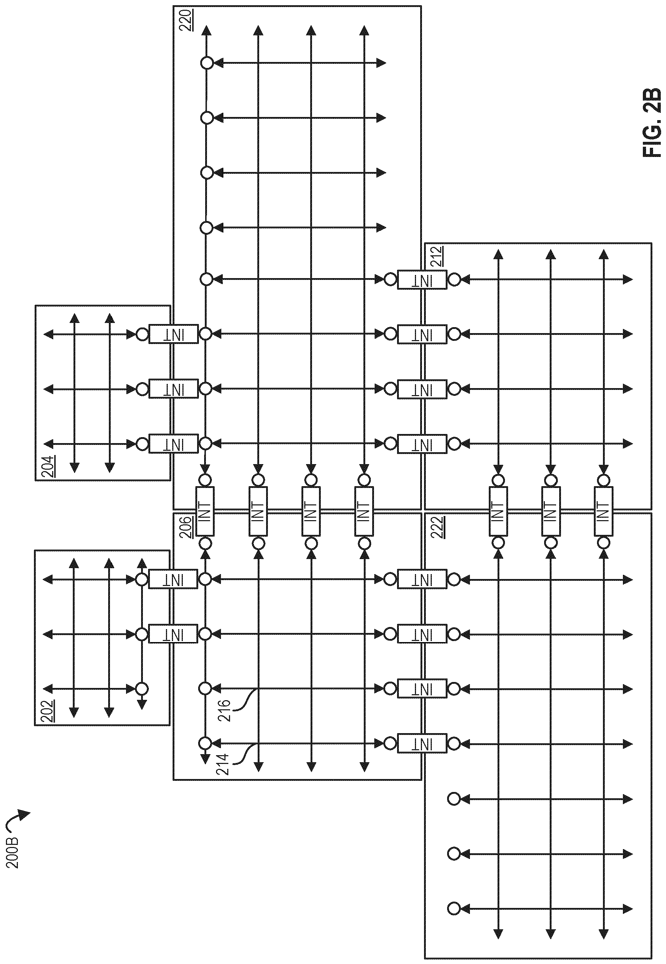

**Figure 2B** illustrates a hardware processor 200B according to embodiments of the disclosure. In the depicted embodiment, die 202 and 204 are smaller than die 206, die 220, die 222, and die 212. Die 220 is depicted as including a different mesh interconnect than die 222, e.g., having a different number of intersections. Figure 2B illustrates that certain of a plurality of dies may be different in certain embodiments (e.g., in one embodiment, they are not symmetric). Figure 2B illustrates that a mesh interconnect on a die may be different than another mesh interconnect on a different die in certain embodiments (e.g., in one embodiment, they are not symmetric).

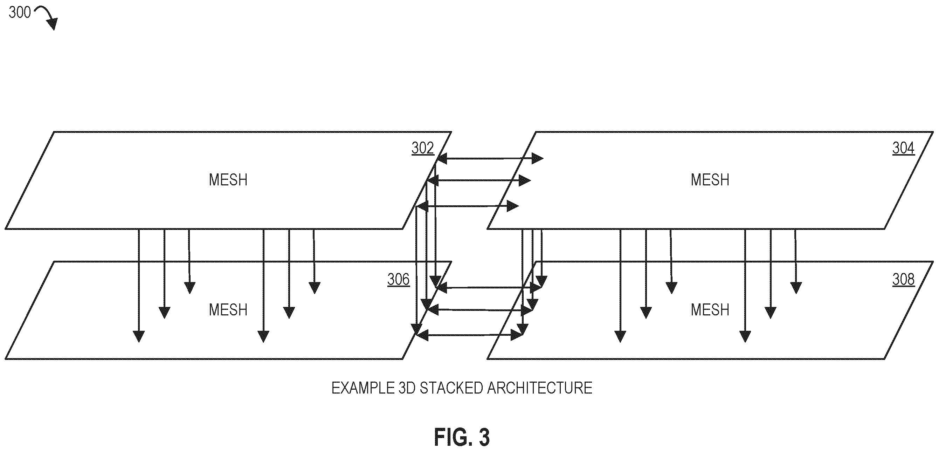

**Figure 3** illustrates a hardware processor 300 according to embodiments of the disclosure. A mesh interconnect is not shown in each die for clarity, but it may be utilized, e.g., as in Figures 1 or 2. Figure 3 illustrates a three dimensional stacked architecture. A plurality of dies may extend in any single direction (e.g., with an interconnect(s) between each die). In the depicted embodiment, die 302 and die 304 extend in a first, single plane and die 306 and die 308 extend in a second, different single plane that is laterally spaced from the first single plane. A die may be affixed to another substrate, e.g., a mounting substrate (not depicted).

In certain embodiments, a first die communicates with (e.g., to and/or from) one or more other dies, e.g., via an electrical connection therebetween. A transceiver (e.g., including a transmitter circuit and/or receiver circuit) may be utilized in one or more of the dies and/or in an interconnect between the dies. A transceiver (e.g., transceiver circuit) may include a physical transport layer (e.g., PHY) circuit (e.g., Input/Output PHY or I/O PHY). Transceivers may be used for communication between multiple dies, e.g., multiple dies that comprise a split-die processor arrangement. In one embodiment, one or more of multiple dies has one or more of its I/O ports (e.g., mesh wires) electrically coupled to the I/O ports (e.g., mesh wires) of another die or dies. In one embodiment, one or more of multiple dies includes a mesh interconnect within the die and each mesh interconnect may have one or more of its I/O ports (e.g., mesh wires) electrically coupled to the I/O ports (e.g., mesh wires) of a mesh interconnect of another die, e.g., at a die boundary crossing. An electrical coupling of dies may be customized for optimized power and latency performance. The couplings (e.g., wires) may be bi-directional, uni-directional, or a combination of both. The physical medium connecting and allowing signaling between the multiple die transceivers (e.g., I/O PHYs) may be an interconnect or other electrical connection.

The transceiver (e.g., I/O PHY) lanes and/or interconnect lanes (e.g., communication lanes) may be programmable to run in multiples of the processor (e.g., mesh interconnect) (e.g., on die) wire data transmittal rates (e.g., data rates). For example, a one times (1X) (e.g., PHY) rate of clocking of data (e.g., clocking rate) is a 1:1 ratio between the interconnect and\or transceiver (e.g., PHY I/O) (e.g., lane) data transmittal rate (e.g., data rate) and the die (e.g., mesh interconnect or mesh wire) data transmittal rate (e.g., data rate). For example, a two times (2X) (e.g., PHY) rate of clocking of data (e.g., clocking rate) is a 2:1 ratio between the interconnect and\or transceiver (e.g., PHY I/O) (e.g., lane) data transmittal rate (e.g., data rate) and the die (e.g., mesh interconnect or mesh wire) data transmittal rate (e.g., data rate). In one embodiment, the interconnect and the portions of the transceiver coupled directly to the interconnect have the same data rate, e.g., different than a die's internal (e.g., intra-mesh) interconnect data rate. As another example, other ratios are possible, e.g., 3X, 4X, 5X, 6X, 7X, 8X, 9X, 10X, etc. The clocking scheme for the transceiver (e.g., PHY I/O) may be source-synchronous (e.g., for higher bandwidth performance per wire) or common-clock (e.g., for lower bandwidth targets).

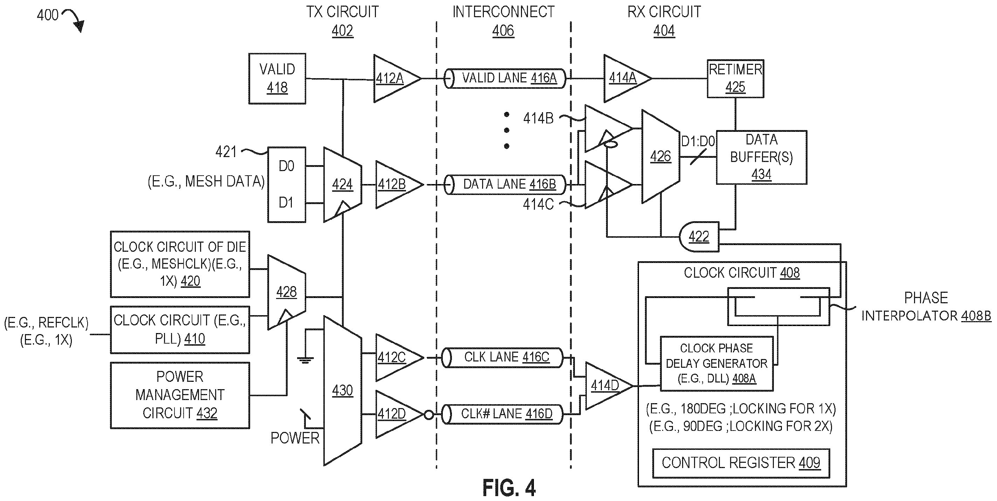

**Figure 4** illustrates a transmitter circuit 402 of a first die coupled to a receiver circuit 404 of a second die through an interconnect 406 according to embodiments of the disclosure. Figure 4 shows a high-level (e.g., source-synchronous clocking) circuit diagram for a transceiver (e.g., PHY I/O) connecting two dies together, e.g., for a data transfer therebetween. Transmitter circuit 402 includes a plurality of transmitters (412A, 412B, 412C, 412D) that produce (e.g., amplify) signals. Receiver circuit 404 includes a plurality of receivers (414A, 414B, 414C, 414D) (e.g., samplers) that receives transmitted signals. Interconnect 406 includes a plurality of lanes (416A, 416B, 416C, 416D). An interconnect may have any one or more of these lanes in certain embodiments. An interconnect may include a plurality of each of these lanes in certain embodiments. In one embodiment, each of these lanes is a discrete wire of the interconnect. Although a single data lane 416 is depicted, a plurality of data lanes (e.g., including one or more respective instances of one or more of the components of the transceiver circuit 402 and/or the receiver circuit 404) may be utilized, e.g., with a single clock lane associated with those multiple data lanes.

In certain embodiments, transceiver circuit 402, interconnect 406, and/or receiver circuit 404 (e.g., any one of those or any combination thereof) include a circuit (e.g., clock circuit) to change operating frequency and/or a clock rate for that operating frequency. In certain embodiments, a clock phase placement (e.g., as discussed herein) is determined (e.g., predetermined) for the operating frequency or frequencies and/or the clocking rate or rates for those operating frequency or frequencies. As an example, data to be transmitted from a first die to a second die may be received by transmitter circuit 402 of the first die and then sent to a second die via receiver circuit 404 through interconnect 406. The first die may be operating at an operating frequency and the second die may be operating at an (e.g., the same) operating frequency, but a clock circuit (e.g., clock circuit 408) may adjust the clock phase placement for the operating frequency (e.g., and a clocking rate for the operating frequency) from a plurality of clock phase placements (e.g., for the same clock cycle). For example, the clock phase placement for the operating frequency may be selected such that no or a minimal amount of data is lost during transmittal. In one embodiment, an intra-die interconnect operates at multiple clocking rate relative to an operating frequency of a different (e.g., inter-die) interconnect of a die or dies coupled to the intra-die interconnect.

As one example, transmitter circuit 402 may receive data from a data generator 421 of a first die that is to be transmitted to receiver circuit 404 (e.g., second die including receiver circuit 404). Data generator 421 of first die may be a processor (e.g., a processor including a decoder to decode an instruction to decode instruction in an execution unit to execute the decoded instruction to generate the data) of the first die. Data to be transmitted may include first data (e.g., data stream) (e.g., data D0) and (e.g., separate) second data (e.g., data stream) (e.g., data D1).

A clock signal (e.g., from or based on the clock signal in first die) from the transmitter circuit 402 (e.g., transmitter side) may be sent (e.g., forwarded) along with (e.g., concurrently with) the data (e.g., payload data) being sent to the receiver circuit 404. Clock circuit 420 may be the internal (e.g., main) clock of the first die (e.g., of the mesh in the first die). Clock circuit 410 may be a separate clock generator, e.g., separate from the internal (e.g., main) clock of the first die, and/or a dedicated clock circuit of the transmitter circuit 402. A multiplexer may select and output one of multiple inputs according to a control signal. Multiplexer (mux) 428 may be set to provide a clock signal from clock circuit 410 or clock circuit 420, e.g., based on a control signal. Multiplexer 428 may be controlled by power management circuit 432, e.g., based on a control signal received from power management circuit (e.g., a power management controller). A power management circuit may control the switching of an operating frequency and/or a clocking rate, for example, the operating frequency and/or a clocking rate in a first die and/or in a second die (e.g., connected via an interconnect to the first die). A local and/or dedicated clock circuit (e.g., clock circuit 410) (e.g., in an I/O PHY) (e.g., phase-locked loop (PLL) circuit) may be employed to enable higher I/O bandwidths by filtering the (e.g., mesh) barrier clock jitter components.

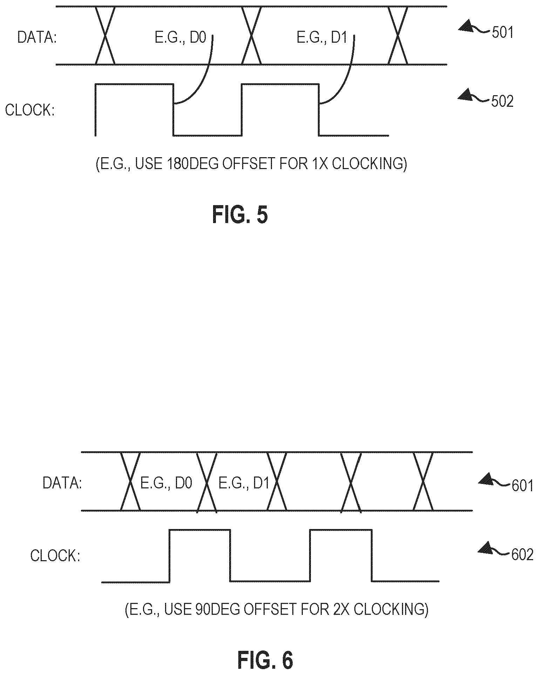

In the depicted embodiment, multiplexer 428 outputs a received clock signal (e.g., the square waveform clock signal in Figures 5 and 6) as a control signal to multiplexer 424. Multiplexer 424 may also take a second input from valid signal circuit 418, e.g., such that multiplexer 424 provides no output when the valid signal circuit 418 indicates invalid (e.g., a logical zero). Multiplexer 424 may then output data (e.g., payload data) from its output to data lane 416B, e.g., via transmitter 412B.

Multiplexer 430 may be included such that the clock signal output from multiplexer 428 passes through both multiplexer 424 and multiplexer 430, e.g., to replicate the delay through multiplexer 424. Multiplexer 430 may have a first input that is ground and a second input that is a power source. In the depicted embodiment, multiplexer 430 outputs its signal to clock lane 416C (e.g., via transmitter 412C) and clock inverse lane 416D (e.g., via transmitter 412D).

Although two data sources (e.g., D0 and D1) (for example, two wires or two signals, e.g., that are to cross a die boundary to another die) are depicted in certain figures herein as sharing a single data lane, it is understood that a single data source (e.g., wire or signal) may utilize a single data lane, e.g., data lane 412.

One or more components of circuit 400 may be switchable from a first clocking rate to a second, different clocking rate, e.g., for each different operating frequency.

By enabling a (e.g., data) valid signal (for example, active only when data is on the connection (for example, a data link, e.g., the one or more lanes of the link) is active (e.g., is to be utilized for data transfer), clock gating may be employed to save power. A valid signal controller 418 may generate a valid signal, e.g., when a first die is to transmit data to a second die. A data signal (e.g., data payload) is separate from a control signal in certain embodiments. Valid signal circuit 418 (e.g., valid signal controller) may be a part of a power management circuit (e.g., power management controller). Power management circuit may be a component of a die. Each die may have its own power management controller. Valid signal circuit 418 may assert a valid signal or invalid signal, e.g. to start or stop (respectively) the receipt and/or passage of data from a first die (e.g., from transmitter circuit 402) to a second die (e.g., to receiver circuit 404) and/or out of second die (e.g., out of receiver circuit 404), e.g., by turning off receivers 414B and/or 414C. Retimer circuit 425 may retime the data valid signal (e.g., out of receiver 414A) based on the clock phase placement.

Receiver circuit 404 may receive a valid signal on the valid lane 416A of interconnect 406, a data signal on data lane 416B of interconnect 406, and/or a clock signal (or inverse signal, or combination of those as a strobe signal) on clock lane 416C and/or clock lane 416D of interconnect 406. Retimer circuit 425 may retime the valid signal such that it is synchronized with the data and/or clock signal(s) that it was sent with. For example, a valid data signal may be sent for one or more streams of data and that signal may be output to AND gate 422. AND gate 422 may receive a clock signal from clock circuit 408 of receiver circuit 404, e.g., such that the output of AND gate 422 is used to turn on one of the plurality of receivers 414B and 414C (e.g., where a NOT gate (an inverter) is included before the control signal input into receiver 414B).

As shown in Figure 5, this allows the serial transmittal of data from source D0, then source D1, then source D0 again, and repeating that so that the data signals alternate between D0 and D1 (e.g., subject to whatever data signal is being output, e.g., logical high (e.g., a one) or logical low (e.g., a zero)). Multiplexer 426 may thus alternate between outputting data from receiver 414B and from receiver 414C. Control signal (e.g., output of AND gate 422) is used to switch multiplexer 426 inputs between sourcing an output from receiver 414B and from receiver 414C.

Depicted clock circuit 408 receives an input clock signal or signals from the transmitter circuit 402 and is to align one or more of the clock edges and the received data signals (e.g., payload data on data lane 416B, which may be more than one data lane) such that the received data is correctly received (e.g., such that the data sent from transmitter circuit 402 matches the data received at receiver circuit 404. In one embodiment, the clock circuit 408 is to shift the phase (and not the frequency) of the received clock signal to align it as desired with the received data signal (e.g., payload data on data lane 416B).

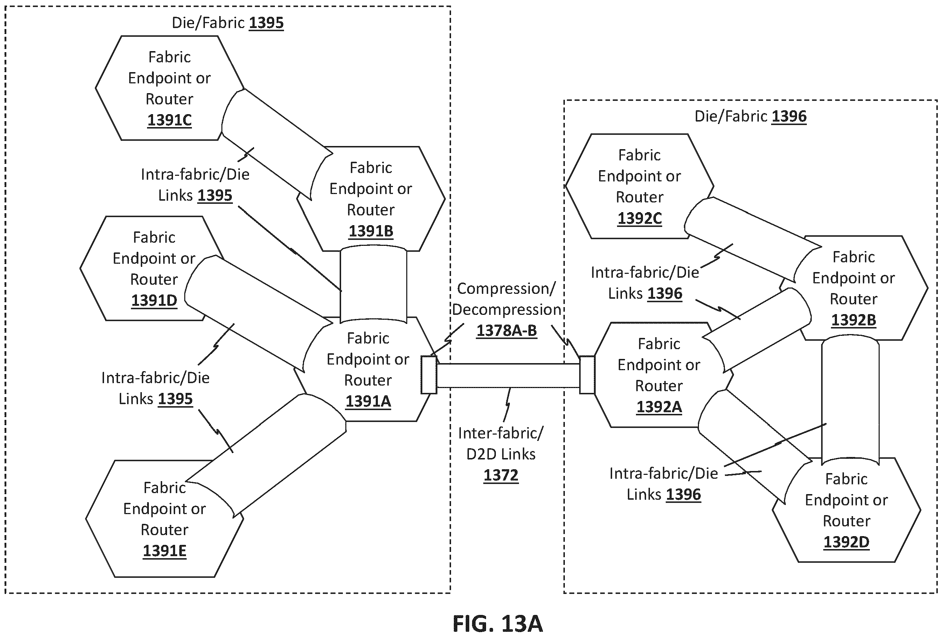

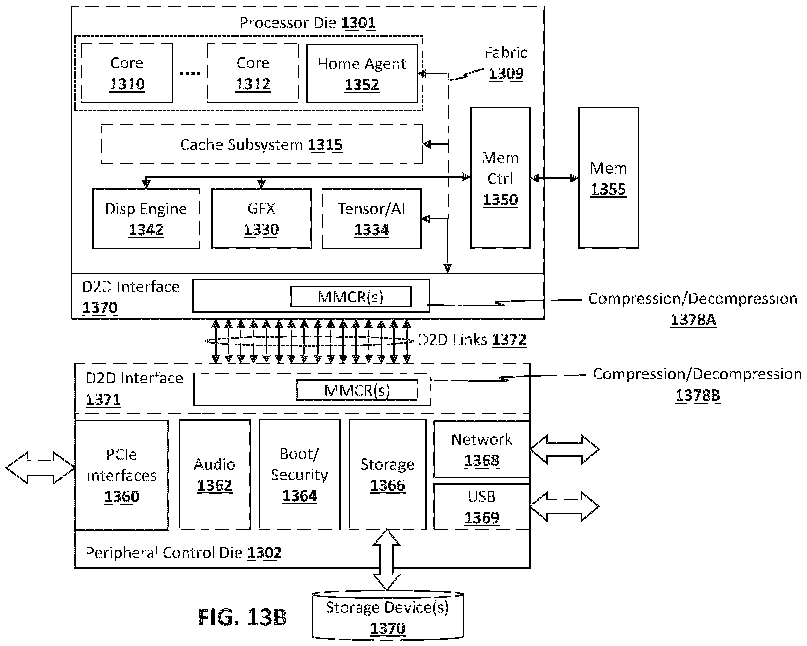

In one embodiment, clock circuit 408 of receiver circuit 404 includes circuitry to align (e.g., shift) the (e.g., source-synchronous) clock edges of a received clock signal (e.g., waveform) from the transmitter circuit 402 with the corresponding received data signal (e.g., different than a clock signal) for high-performance timing, e.g., such that the data in the data signal is not altered, lost, destroyed, or any combination thereof. Clock circuit 408 may include a clock phase delay generator 408A (e.g., DLL circuit) and/or phase interpolator circuit 408B. In one embodiment, clock phase placement is performed by a phase interpolator e.g. phase interpolator circuit 408B. In one embodiment, a phase interpolator is a circuit that adjusts (e.g., shifts) the phase of a clock signal. In one embodiment, a phase interpolator has a level (e.g., 2, 4, 6, 8, 10, 12, etc.) of granularity of steps per each clock phase e.g., that are equally spaced apart and it may set a rising clock edge and/or falling clock edge at any of those steps, for example, as discussed further in reference to Figure 13 below.

Clock circuit 408, e.g., including a delay-locked loop (DLL) circuit, may be employed at the receiver circuit 404 of the receiver die to appropriately align the source-synchronous clocking edge for high-performance timing (e.g., to enable effective high-speed signaling). A DLL circuit may be a negative-delay gate placed in the clock path of a digital circuit. In one embodiment, clock circuit 408 is a component of receiver circuit 404. A local and/or dedicated clock circuit (e.g., clock circuit 410) (e.g., in an I/O PHY) (e.g., phase-locked loop (PLL) circuit) may be employed to enable higher I/O bandwidths by filtering the (e.g., mesh) barrier clock jitter components. PLL circuit may be a control circuit that generates an output signal whose phase is related to the phase of an input signal. Although there are different types of PLL circuits, one example is a circuit with a variable frequency oscillator and a phase detector in a feedback loop, e.g., where the oscillator generates a periodic signal, the phase detector compares the phase of that signal with the phase of the input periodic signal, and adjusts the oscillator to keep the phases matched. A PLL may be an all digital PLL (ADPLL). In one embodiment, a DLL circuit uses a variable phase (e.g., delay) block and a PLL circuit uses a variable frequency block. Clock circuit 408 may include a control register 409, for example, to store the clock phase placement settings, e.g., to cause clock circuit 408 to apply those settings.

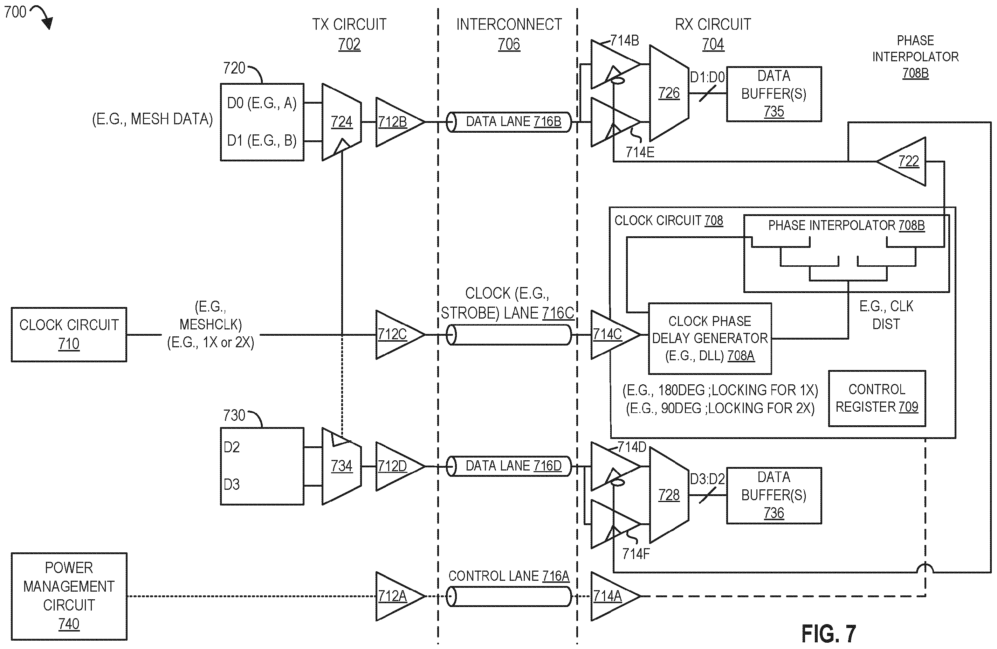

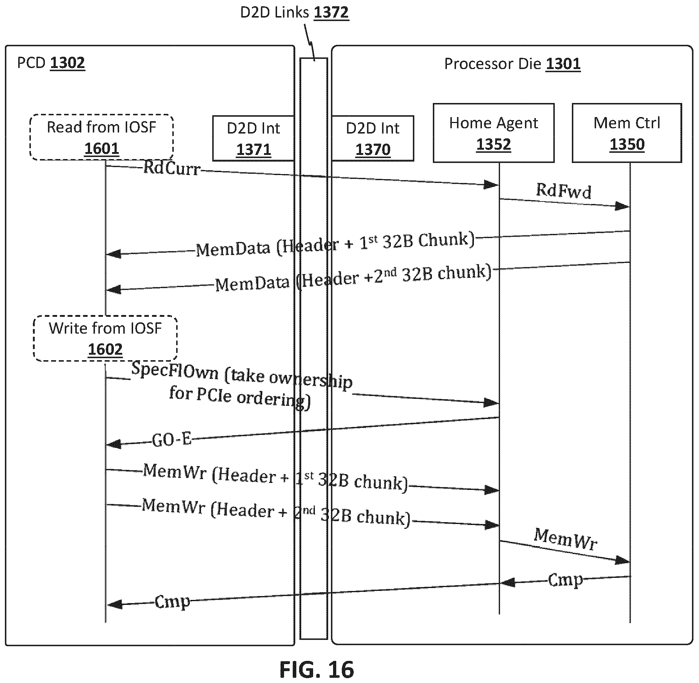

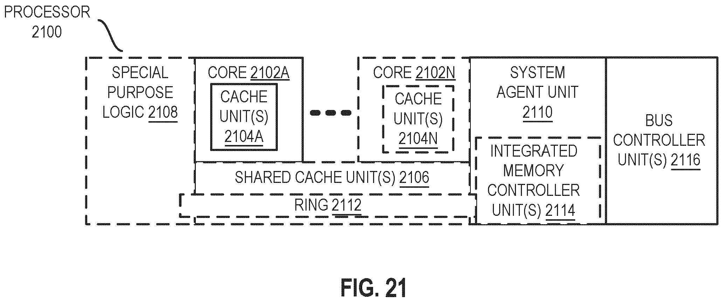

To maintain high power efficiency for the transmitter circuit and/or receiver circuit (e.g., I/O PHY), techniques such as low swing signaling, clock-gating, and aggregating the source-synchronous clocking power between a plurality (e.g., a large number) of serviced data lanes may be employed. For example, one forwarded source-synchronous clock may be utilized for each of 2, 3, 4, 5, 6, 7, 8, 16, 32, 64, 128, 256, etc. data lanes or any subset thereof. Data lane 416B is merely an example and a plurality of lanes may be utilized.
In certain embodiments, clock phase delay generator 408A (e.g., DLL circuit) generates lock (e.g., not clock) timing (e.g., as in Figure 16) for a clock rate of an operating frequency (for example, clock phase locking of 90 degrees or 180 degrees, e.g., as in Figures 6 and 7, respectively). In certain embodiments, phase interpolator circuit 408B subdivides those clock signals into a finer granularity. In certain embodiments, clock circuit 408 utilizes predetermined (e.g., before the current data transmittal) clock phase placement data, e.g., both clock phase delay generator 408A (e.g., DLL circuit) and/or phase interpolator circuit 408B utilize predetermined clock phase placement data. In one embodiment, clock phase delay generator 408A is a clock phase controller or clock phase adjuster. In one embodiment, clock phase delay generator 408A maintains a certain phase relationship of the clock arriving at the receivers (e.g., samplers) (e.g., of a second die) with respect to the input clock or clocks coming in from the transmitter (e.g., of a first die). In certain embodiments, the clock phase delay generator 408A generates the clock phase delay and the phase interpolator circuit 408B is to further subdivide those clock signals into the finer granularity. In one embodiment, clock phase delay generator 408A looks up and utilizes a lock code for a particular clocking rate and/or operating frequency, and/or phase interpolator circuit 408B looks up and utilizes the buffer settings for the phase interpolator for the particular clocking rate and/or operating frequency. For example, a lock code (e.g., of a DLL) may change for each frequency and/or each process, voltage, and/or temperature point (e.g., of a plurality of points) and a phase interpolator circuit may perform the (e.g., finer granularity) clock (e.g., edge) placement within that (e.g., DLL) lock code. Once the (e.g., predetermined) clock phase placement for the operating frequency and clocking rate are looked-up and updated into the circuitry (e.g., clock circuit 408), data may be received by receiver circuit, for example, output to data buffers 434 (e.g., as in Figure 21).

**Figure 5** illustrates a data timing diagram 501 and a clock timing diagram 502 for a first clocking rate according to embodiments of the disclosure. In the depicted embodiment, clock timing diagram 501 illustrates a 180 degree offset of the clock signal (e.g., clock_180 in Figure 16) used to clock in data relative to the clock signal received at the receiver for a 1X clocking rate. Data timing diagram 501 illustrates that the data (e.g., alternating D0 and D1 data transmitted with the circuit 400 of Figure 4) in the 1X clocking rate may be read in at each falling edge of the clock. As discussed herein, predetermined clock phase placement (e.g., relative to the data timing) may be utilized to place the clock edges.

**Figure 6** illustrates a data timing diagram 601 and a clock timing diagram 602 for a second clocking rate according to embodiments of the disclosure. In the depicted embodiment, clock timing diagram 601 illustrates a 90 degree offset of the clock signal (e.g., clock_90 in Figure 16) used to clock in data relative to the clock signal received at the receiver for a 2X clocking rate. Data timing diagram 601 illustrates that the data (e.g., alternating D0 and D1 data transmitted with the circuit 400 of Figure 4) in the 2X clocking rate may be read in at each of the rising and falling edge of the clock. As discussed herein, predetermined clock phase placement (e.g., relative to the data timing) may be utilized to place the clock edges.

Figure 7 illustrates a transmitter circuit 702 of a first die coupled to a receiver circuit 704 of a second die through an interconnect 706 according to embodiments of the disclosure. Figure 7 shows a high-level (e.g., source-synchronous clocking) circuit diagram for a transceiver (e.g., PHY I/O) connecting two dies together, e.g., for a data transfer therebetween. Transmitter circuit 702 includes a plurality of transmitters (712A, 712B, 712C, 712D) that produce (e.g., amplify) signals. Receiver circuit 704 includes a plurality of receivers (714A, 714B, 714C, 714D, 714E, 714F) that receives transmitted signals. Interconnect 706 includes a plurality of lanes (716A, 716B, 716C, 716D). An interconnect may have any one or more of these lanes in certain embodiments. An interconnect may include a plurality of each of these lanes in certain embodiments. In one embodiment, each of these lanes is a discrete wire of the interconnect. Although two data lanes (i.e., data lanes 716B and 716D) are depicted, a single data or three or more data lanes (e.g., including one or more respective instances of one or more of the components of the transceiver circuit 702 and/or the receiver circuit 704) may be utilized, e.g., with a single clock lane associated with those multiple data lanes. For example, a single data source (e.g., D0) may be utilized, e.g., by removing the control signal line from clock circuit 710 to multiplexer 724 (and/or removing multiplexer 724 and/or outputting data from data lane 716B directly to a single receiver (e.g., receiver 714E) without using multiplexer 726.

In certain embodiments, transceiver circuit 702, interconnect 706, and/or receiver circuit 704 (e.g., any one of those or any combination thereof) include a circuit (e.g., clock circuit) to change in operating frequency and/or a clock rate for that operating frequency. In certain embodiments, a clock phase placement (e.g., as discussed herein) is determined (e.g., predetermined) for the operating frequency or frequencies and/or the clocking rate for those operating frequency or frequencies. As an example, data (e.g., payload data) to be transmitted from a first die to a second die may be received by transmitter circuit 702 and then sent to a second die via receiver circuit 704 through interconnect 706. The first die may be operating at an operating frequency and the second die may be operating (e.g., switched to) at an (e.g., the same) operating frequency, but a clock circuit (e.g., clock circuit 708) may adjust the clock phase placement for the operating frequency (e.g., and a clocking rate for the operating frequency) from a plurality of clock phase placements (e.g., for the same clock cycle). For example, the clock phase placement for the operating frequency may be selected such that no or a minimal amount of data is lost during transmittal.

As one example, transmitter circuit 702 may receive data from data generator 720 and/or data generator 730 (e.g., which may be combined into a single data generator) of a first die that is to be transmitted to receiver circuit 704 (e.g., second die including receiver circuit 704). Data generator 720 and/or data generator 730 of first die may be a processor or processors (e.g., each processor including a decoder to decode an instruction to decode instruction in an execution unit to execute the decoded instruction to generate the data) of the first die. Data to be transmitted may include any of first data (e.g., data stream) (e.g., data D0), (e.g., separate) second data (e.g., data stream) (e.g., data D1), (e.g., separate) third data (e.g., data stream) (e.g., data D2), (e.g., separate) fourth data (e.g., data stream) (e.g., data D3), or any combination thereof.

A clock signal (e.g., from or based on the clock signal in first die) from the transmitter circuit 702 (e.g., transmitter side) may be sent (e.g., forwarded) along with (e.g., concurrently with) the data (e.g., payload data) being sent to the receiver circuit 704. Clock circuit 710 may be the internal (e.g., main) clock of the first die (e.g., of the mesh in the first die), a separate clock generator, e.g., separate from the internal (e.g., main) clock of the first die, and/or a dedicated clock circuit of the transmitter circuit 702.

As a component of or separate from interconnect 706, circuit 700 (or other circuits herein) may include a control lane to send a control signal from a first die (e.g., via transmitter circuit 702) to second die (e.g., via receiver circuit 704). Control signal may be sent by power management circuit 740 (e.g., a power management controller), e.g., sent to receiver circuit 704 (e.g., clock circuit 708 of receiver circuit 704 and/or second die). Control signal may switch a circuit (e.g., a clock circuit) between a closed-loop mode and an open-loop mode. Power management circuit may control the switching of an operating frequency and/or a clocking rate, for example, the operating frequency and/or a clocking rate in a first die and/or in a second die (e.g., connected via an interconnect to the first die). A local and/or dedicated clock circuit (e.g., clock circuit 710) (e.g., in an I/O PHY) (e.g., phase-locked loop (PLL) circuit) may be employed to enable higher I/O bandwidths by filtering the (e.g., mesh) barrier clock jitter components. In one embodiment, a first die is to request a second die (e.g., both dies) to operate at a different frequency and/or clocking rate based on usage, for example, operating at a (e.g., single) frequency and increasing the clocking rate when data is backing up (e.g., in a buffer in the first die) and/or at a (e.g., single) frequency and decreasing the clocking rate when data is not backing up (e.g., an empty or not filled buffer in the first die).

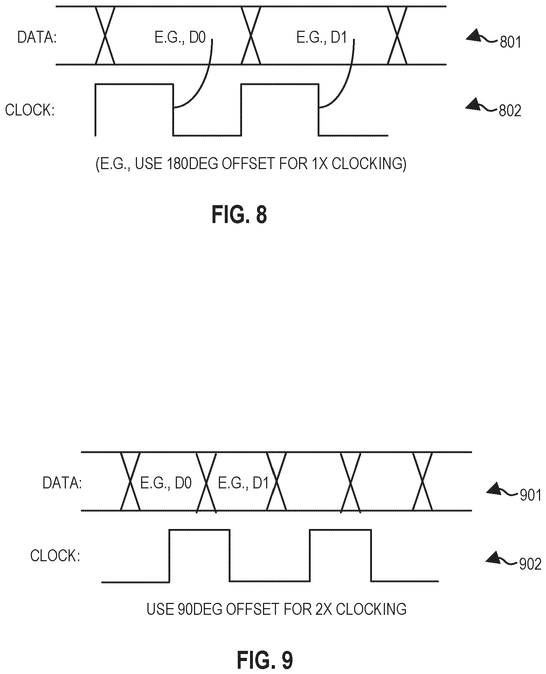

In the depicted embodiment, clock circuit 710 outputs a clock signal (e.g., the square waveform clock signal in Figures 8 and 9) as a control signal to multiplexer 724 and/or multiplexer 734. Multiplexer 724 may then output data (e.g., payload data) from its output to data lane 716B, e.g., via transmitter 712B and/or multiplexer 734 may then output data (e.g., payload data) from its output to data lane 716D, e.g., via transmitter 712D. Clock signal may be transmitted from transmitter circuit 702 to transmitter 712C, through clock (e.g., strobe) lane 716C (e.g., of interconnect 706) to receiver 714C of receiver circuit 704, e.g., and then to clock circuit 708.

Although two pairs of data sources (e.g., D0/D1 and D2/D3) (for example, four wires or four signals, e.g., that are to cross a die boundary to another die) are depicted in certain figures herein as sharing a single data lane, it is understood that a single data source (e.g., wire or signal) may utilize a single data lane, e.g., data lane 716B or data lane 716D.

One or more components of circuit 700 may be switchable from a first clocking rate to a second, different clocking rate, e.g., for each different operating frequency.

By enabling a (e.g., data) control signal (for example, active only when data is on the connection (for example, a data link, e.g., the one or more lanes of the link) is active (e.g., is to be utilized for data transfer), clock gating may be employed to save power. A power management circuit 740 (e.g., power management controller) may generate a valid data and/or frequency change and/or clocking rate change signal, e.g., when a first die is to transmit data to a second die. A data signal (e.g., data payload) is separate from a control signal in certain embodiments. Power management circuit may be a component of a die. Each die may have its own power management controller. Power management circuit may assert a valid signal or invalid signal, e.g. to start or stop (respectively) the receipt and/or passage of data from a first die (e.g., from transmitter circuit 702) to a second die (e.g., to receiver circuit 704) and/or out of second die (e.g., out of receiver circuit 704), e.g., by turning off transmitter(s) and/or receiver(s).

Receiver circuit 704 may receive a control signal (e.g., to change the frequency and/or clocking rate) on the control lane 716A of interconnect 706, a data signal on data lane 716B of interconnect 706, a data signal on data lane 716D of interconnect 706, and/or a clock signal (or inverse signal, or combination of those as a strobe signal) on clock lane 716C of interconnect 706. For example, power management circuit 740 may send a signal to receiver circuit 704 (e.g., clock circuit 708 thereof) to enable a certain frequency and/or clocking rate for the receiver circuit 704 (e.g., clock circuit 708 thereof), e.g., the same frequency and/or clocking rate of the transmitter circuit 702.

Receiver 722 may receive a clock signal from clock circuit 708 of receiver circuit 704, e.g., such that the output of receiver 722 is used to turn on one of the plurality of receivers 714B and 714E (e.g., where a NOT gate (an inverter) is included before the control signal input into receiver 714B) (e.g., and turn off the other receiver of the pair) and/or turn on one of the plurality of receivers 714D and 714F (e.g., where a NOT gate (an inverter) is included before the control signal input into receiver 714D) (e.g., and turn off the other receiver of the pair). As shown in Figure 8, this allows the serial transmittal of data from source D0, then source D1, then source D0 again, and repeating that so that the data signals alternate between D0 and D1 (e.g., subject to whatever data signal is being output, e.g., logical high (e.g., a one) or logical low (e.g., a zero)) and/or (e.g., in parallel with the serial sending of D0 and D1) the serial transmittal of data from source D2, then source D3, then source D2 again, and repeating that so that the data signals alternate between D2 and D3 (e.g., subject to whatever data signal is being output, e.g., logical high (e.g., a one) or logical low (e.g., a zero)). Multiplexer 726 may thus alternate between outputting data from receiver 714B and from receiver 714E. Control signal (e.g., output of receiver 722) (e.g., the received source synchronous clock after it has gone through the DLL/PI/clock distribution circuitry) is used to switch multiplexer 726 inputs between sourcing an output from receiver 714B and from receiver 714E. Multiplexer 728 may thus alternate between outputting data from receiver 714D and from receiver 714F. Control signal (e.g., output of receiver 722) (e.g., the received source synchronous clock after it has gone through the DLL/PI/clock distribution circuitry) is used to switch multiplexer 728 inputs between sourcing an output from receiver 714D and from receiver 714F.

Depicted clock circuit 708 receives an input clock signal or signals from the transmitter circuit 702 and is to align one or more of the clock edges and the received data signals (e.g., payload data on data lane 716B and/or data lane 716D, and which may be more than two data lanes) such that the received data is correctly received (e.g., such that the data sent from transmitter circuit 702 matches the data received at receiver circuit 704. In one embodiment, the clock circuit 708 is to shift the phase (and not the frequency) of the received clock signal to align it as desired with the received data signal (e.g., payload data on data lane 716B and/or data lane 716D).

In one embodiment, clock circuit 708 of receiver circuit 704 includes circuitry to align (e.g., shift) the (e.g., source-synchronous) clock edges of a received clock signal (e.g., waveform) from the transmitter circuit 702 with the corresponding received data signal (e.g., different than a clock signal) for high-performance timing, e.g., such that the data in the data signal is not altered, lost, destroyed, or any combination thereof. Clock circuit 708 may include a clock phase delay generator 708A (e.g., DLL circuit) and/or phase interpolator circuit 708B. In one embodiment, clock phase placement is performed by a phase interpolator e.g. phase interpolator circuit 708B. In one embodiment, a phase interpolator is a circuit that adjusts (e.g., shifts) the phase of a clock signal. In one embodiment, a phase interpolator has a level (e.g., 2, 4, 6, 8, 10, 12, etc.) of granularity of steps per each clock phase e.g., that are equally spaced apart and it may set a rising clock edge and/or falling clock edge at any of those steps, for example, as discussed further in reference to Figure 13 below.

Clock circuit 708, e.g., including a delay-locked loop (DLL) circuit, may be employed at the receiver circuit 704 of the receiver die to appropriately align the source-synchronous clocking edge for high-performance timing (e.g., to enable effective high-speed signaling). A DLL circuit may be a negative-delay gate placed in the clock path of a digital circuit. In one embodiment, clock circuit 708 is a component of receiver circuit 704. A local and/or dedicated clock circuit (e.g., clock circuit 710) (e.g., in an I/O PHY) (e.g., phase-locked loop (PLL) circuit) may be employed to enable higher I/O bandwidths by filtering the (e.g., mesh) barrier clock jitter components. PLL circuit may be a control circuit that generates an output signal whose phase is related to the phase of an input signal. Although there are different types of PLL circuits, one example is a circuit with a variable frequency oscillator and a phase detector in a feedback loop, e.g., where the oscillator generates a periodic signal, the phase detector compares the phase of that signal with the phase of the input periodic signal, and adjusts the oscillator to keep the phases matched. A PLL may be an all digital PLL (ADPLL). In one embodiment, a DLL circuit uses a variable phase (e.g., delay) block and a PLL circuit uses a variable frequency block. Clock circuit 708 may include a control register 709, for example, to store the clock phase placement settings, e.g., to cause clock circuit 708 to apply those settings.

To maintain high power efficiency for the transmitter circuit and/or receiver circuit (e.g., I/O PHY), techniques such as low swing signaling, clock-gating, and aggregating the source-synchronous clocking power between a plurality (e.g., a large number) of serviced data lanes may be employed. For example, one forwarded source-synchronous clock may be utilized for each of 2, 3, 4, 5, 6, 7, 8, 16, 32, 64, 128, 256, etc. data lanes or any subset thereof. Data lane 716B is merely an example and a plurality of lanes may be utilized.
In certain embodiments, clock phase delay generator 708A (e.g., DLL circuit) generates lock (e.g., not clock) timing (e.g., as in Figure 16) for a clock rate of an operating frequency (for example, clock phase locking of 90 degrees or 180 degrees, e.g., as in Figures 8 and 9, respectively). In certain embodiments, phase interpolator circuit 708B subdivides those clock signals into a finer granularity. In certain embodiments, clock circuit 708 utilizes predetermined (e.g., before the current data transmittal) clock phase placement data, e.g., both clock phase delay generator 708A (e.g., DLL circuit) and/or phase interpolator circuit 708B utilize predetermined clock phase placement data. In one embodiment, clock phase delay generator 708A is a clock phase controller or clock phase adjuster. In one embodiment, clock phase delay generator 708A maintains a certain phase relationship of the clock arriving at the receivers (e.g., samplers) (e.g., of a second die) with respect to the input clock or clocks coming in from the transmitter (e.g., of a first die). In certain embodiments, the clock phase delay generator 708A generates the clock phase delay and the phase interpolator circuit 708B is to further subdivide those clock signals into the finer granularity. In one embodiment, clock phase delay generator 708A looks up and utilizes a lock code for a particular clocking rate and/or operating frequency, and/or phase interpolator circuit 708B looks up and utilizes the buffer settings for the phase interpolator for the particular clocking rate and/or operating frequency. For example, a lock code (e.g., of a DLL) may change for each frequency and/or each process, voltage, and/or temperature point (e.g., of a plurality of points) and a phase interpolator circuit may perform the (e.g., finer granularity) clock (e.g., edge) placement within that (e.g., DLL) lock code. Once the (e.g., predetermined) clock phase placement for the operating frequency and clocking rate are looked-up and updated into the circuitry (e.g., clock circuit 708), data may be received by receiver circuit, for example, output to data buffers 735 and/or data buffers 736 (e.g., as in Figure 21). In one embodiment, a first die includes one or more transmitter circuits (e.g., transmitter circuit 402 of Figure 4 or transmitter circuit 702 of Figure 7) and a second die includes one or more receiver circuits (e.g., receiver circuit 404 of Figure 4 or receiver circuit 704 of Figure 7). Additionally or alternatively, that second die may include one or more transmitter circuits (e.g., transmitter circuit 402 of Figure 4 or transmitter circuit 702 of Figure 7) and that first die may include one or more receiver circuits (e.g., receiver circuit 404 of Figure 4 or receiver circuit 704 of Figure 7), e.g., to allow two-way communication between the dies.

**Figure 8** illustrates a data timing diagram 801 and a clock timing diagram 802 for a first clocking rate according to embodiments of the disclosure. In the depicted embodiment, clock timing diagram 801 illustrates a 180 degree offset of the clock signal (e.g., clock_180 in Figure 16) used to clock in data relative to the clock signal received at the receiver for a 1X clocking rate. Data timing diagram 801 illustrates that the data (e.g., alternating D0 and D1 data and/or alternating D2 and D3 data transmitted with the circuit 700 of Figure 7) in the 1X clocking rate may be read in at each falling edge of the clock. As discussed herein, predetermined clock phase placement (e.g., relative to the data timing) may be utilized to place the clock edges.

**Figure 9** illustrates a data timing diagram 901 and a clock timing diagram 902 for a second clocking rate according to embodiments of the disclosure. In the depicted embodiment, clock timing diagram 901 illustrates a 90 degree offset of the clock signal (e.g., clock_90 in Figure 16) used to clock in data relative to the clock signal received at the receiver for a 2X clocking rate. Data timing diagram 901 illustrates that the data (e.g., alternating D0 and D1 data and/or alternating D2 and D3 data transmitted with the circuit 700 of Figure 7) in the 2X clocking rate may be read in at each of the rising and falling edge of the clock. As discussed herein, predetermined clock phase placement (e.g., relative to the data timing) may be utilized to place the clock edges.

In one embodiment, an I/O PHY circuit (e.g., the transmitter circuit of one die and receiver circuit of another die or dies) is capable of (e.g., quickly) changing between different clocking rates (e.g., data rates) (e.g., 1X, 2X, 4X, etc.) and/or clock frequency rate changes, e.g., to support an interconnect employed in the mesh of a die. In certain embodiments, the clock circuit or circuits (e.g., Delay Locked Loop (DLL) and Phase Interpolator (PI)) used for (e.g., receiver) clocking edge alignment are calibrated for a plurality of (e.g., all) possible clocking rates (e.g., data rates) and/or frequencies, e.g., at initial boot time. In an embodiment where a digital-control DLL+PI is employed, the calibration information for each of the clocking rates (e.g., data rates) and operating frequency configurations is stored (for example, in a memory array, e.g., in clock circuit) and recalled when a circuit (e.g., a die) initiates a clocking rates (e.g., data rates) and/or frequency change (e.g., of the interconnect connecting two or more dies). This may also be accomplished for analog-controlled DLL+PI circuits, for example, by converting analog bias points to digital information using analog to digital (A/D) convertors for storage in a memory array and then a digital to analog (D/A) converter to convert back to analog bias points when updating operating points. These recalled clock (e.g., DLL+PI) calibration settings may be used to override the current clock (e.g., DLL+PI) calibration settings to allow for quick clock (e.g., DLL+PI) lock and/or calibration to the new settings and/or operating point. Certain embodiments herein thus allow rapid transitions between different clocking rates (e.g., data rates) and/or frequencies.

Certain embodiments herein provide for novel circuitry and algorithm to allow fast and dynamic I/O clocking rates (e.g., data rates) and/or frequency changes on the fly. In one embodiment, I/O timing (e.g., clocking rate and/or operating frequency) between dies is facilitated by tuned clock phases (e.g., by a combination of DLL auto-tracking circuitry and training PI sweeps). In one embodiment, the training occurs all at one time (e.g., one training session) (e.g., at manufacturing time, before end users utilize the processor). The I/O clocking architecture may be source-synchronous, e.g., forwarded clock which is tuned to a specific phase relationship with respect to the data lane or lanes of to maximize I/O timing margin. Figure 4 and Figure 7 illustrate examples of the high-level clocking architecture. Figures 5, 6, 8, and 9 illustrate example timing diagrams depicting 1X (single clocking rate) and 2X (double clocking rate) clocking relationships with respect to data eyes (e.g., data eyes D0 and D1 in the upper portions of each of Figures 5, 6, 8, and 9). In certain embodiments, fine-grain control of clock strobe placement allows for maximum performance. Certain embodiments achieve this by a combination of DLL+PI for small phase step granularity (e.g., 1 or about 1 picosecond (ps) increments). Figure 13 (discussed further below) shows example circuit architecture specifics of the digital delay line within a DLL as well as a digital-style PI. The output of that DLL+PI may be either one clock (e.g., use both clock edges to time), or two outputs (e.g., use one clock edge of each to time) or four outputs (e.g., in the case of 4X clocking rate) (e.g., use one clock edge of each clock or alternatively, send out 2 clocks and use both clock edges of each clock to time all 4 data bits per cycle). Note that Figures 5, 6, 8, and 9 show a single clock output (e.g., use one clock edge for 1X clocking rate or both edges to time for 2X clocking rate), but Figure 13 shows two outputs to show that this circuit and method may also be used for 2X clocking, e.g., by using only one clock edge per clock cycle for timing. In certain embodiments, the tuned clock phase will be unique for each frequency point and clocking rate at that frequency point (e.g., as well as unique per instantiation of hardware within a die and/or as well as die to die).

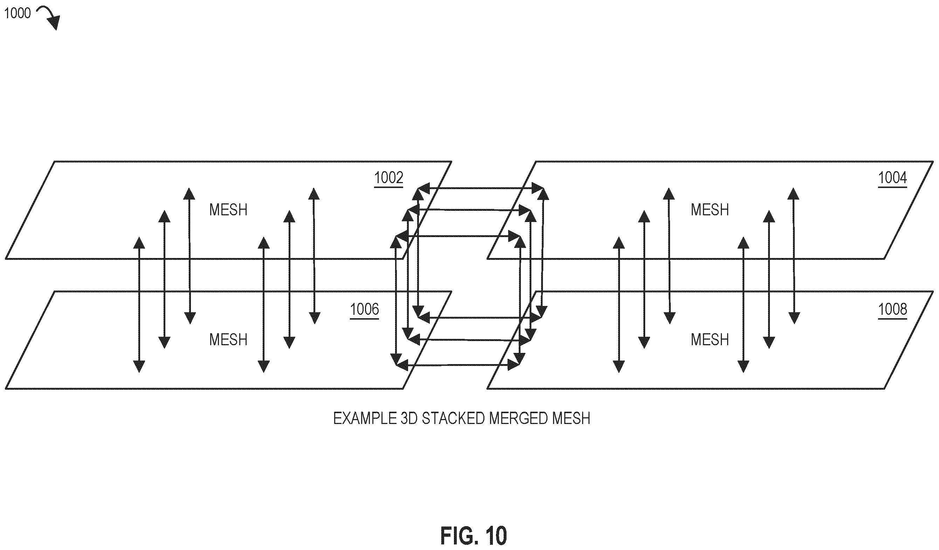

**Figure 10** illustrates a hardware processor 1000 according to embodiments of the disclosure. A mesh interconnect is not shown in each die for clarity, but it may be utilized, e.g., as in Figures 1, 2A, 2B, 33, or 34. Figure 10 illustrates a three dimensional stacked architecture. A plurality of dies may extend in any single direction with an electrical interconnect(s) between each die. In the depicted embodiment, die 1002 and die 1004 extend in a first, single plane and die 1006 and die 1008 extend in a second, different single plane that is laterally spaced from the first single plane. A die may be affixed to another substrate, e.g., a mounting substrate (not depicted).

In one embodiment, multiple die architecture is implemented using silicon interposer (si-interposer) as a physical manufacturing technology. In this realization, the metal wires to implement the bridging between the two or more dies may be implemented in a different die (e.g., silicon) that forms the base of all the other dies. The base die may have through silicon vias (TSVs) to deliver power to the dies and/or route the I/O signals out on to the board/external connectors. Alternately, the base die may not have TSVs and the power delivery and I/O break outs may be provided by some form of peripheral wire-bonding.

Certain embodiments herein provide for multiple physically separate discrete dies to be electrically connected together by an electrical interconnect to form a larger and more capable processor. Certain embodiments herein provide for a single shared cache coherency domain over that interconnect to form a monolithic cache domain over the entire processor. Certain embodiments herein include communication with the native protocol of each die internal data transport and does not require the overhead of packetizing nor serializing the data transmitted or received over an electrical interconnect between dies. Certain embodiments herein allow transportation according to a single or to multiple simultaneous transaction protocols between dies.

Certain embodiments herein allow for multiple dies to have relative clock alignment uncertainty, different power sources, different die fabrication process skew, and different die temperature. Certain embodiments herein allow for one die to run at a different frequency than another die or dies of that hardware processor. Certain embodiments herein allow for the interconnect to have divisible independent power, clock, and/or reset domains to help yield recovery, e.g., by disabling row and/or column of a mesh interconnect. In certain embodiments, an electrical interconnect allows (e.g., very large) cross bandwidth but also having minimal latency and power impact. Certain embodiments herein provide for a mesh loopback design, e.g., to tolerate die to die differences.

Certain embodiments herein add an entry into a look-up table (LUT) (e.g., within a transceiver) to indicate if data (e.g., a cache line) is to cross a physical die boundary to pass through an interconnect between two die. Certain transport protocols herein enable a (e.g., high speed) interconnect between multiple dies and/or seamless crossing of the die boundaries. Alternatively to using those protocols as die to die connection, certain embodiments herein may use other solutions, e.g., utilizing an interposer. Certain interconnects herein include a fabric arbitration block circuit (e.g., in a transceiver) to accommodate uncertainties in transaction destination resource status without forcing the source to delay for a latent indication, as well as accommodating transaction merger into open transaction routing slots in the remote die fabric. In certain embodiments, an electrical interconnect fabric arbitration block circuit (e.g., controller) is located at only one of a receiver circuit or a transmitter circuit. Certain interconnects herein include a post silicon tunable buffer (e.g., a transparent queue (TQ)), e.g., for supporting high bandwidth and low latencies to accomplish the die crossover amid clock alignment uncertainty, different power sources, different die fabrication process skew, and/or different die temperature. In certain embodiments, an electrical interconnect buffer may have no latency impact if both domain are running at the same frequency and managed clock uncertainties despite dies on different power sources, different die fabrication process skew, and different die temperature. In certain embodiments, an electrical interconnect buffer is located at only one of a receiver circuit or a transmitter circuit. In certain embodiments, an interconnect buffer is located at both transmitter and receiver circuits.

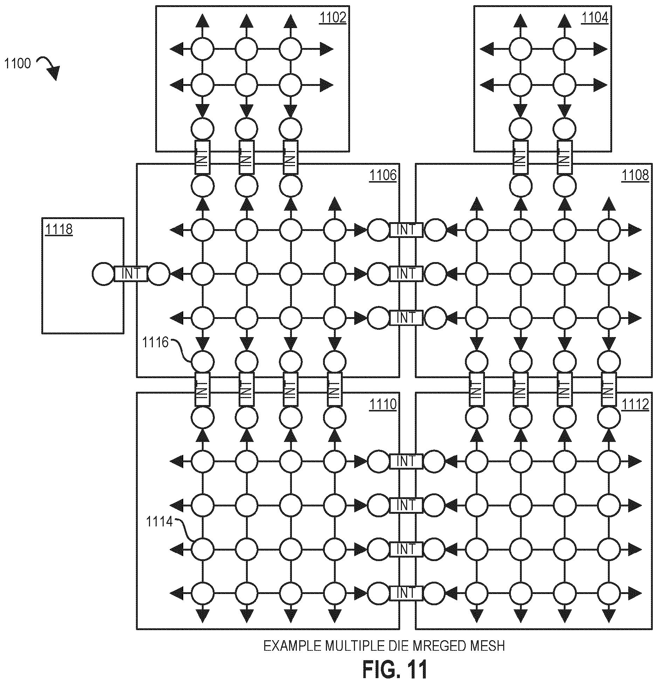

**Figure 11** illustrates a hardware processor 1100 according to embodiments of the disclosure. In the depicted embodiment, die 1102 and 1104 are smaller than die 1106, die 1108, die 1110, and die 1112. Each of the depicted dies is coupled to an adjacent die via an (e.g., inter die) interconnect (INT). Die 1102 is depicted as having two discrete interconnects with die 1106, e.g., interconnects that include one or more instances of receiver circuit(s) and/or one or more instances of transmitter circuit(s) disclosed herein. Die 1104 is depicted as having a different number of (e.g., three) discrete interconnects with die 1108. Die 1106 is depicted as having four discrete interconnects with die 1108. Die 1110 is depicted as having a different number of (e.g., three) discrete interconnects with die 1112. The intersection of mesh interconnect of a die (e.g., intersection 1114 or intersection 1116 of die 1106) may be the access point into the mesh interconnect by a circuit component. In one embodiment, multiple (e.g., any) mesh configurations with different sizes on their respective die are coupled together by certain embodiments herein. In one embodiment, a die with a mesh interconnect is coupled to a die without a mesh interconnect, for example, die 1118 is depicted in Figure 11 as coupled to mesh interconnect of die 1106 though single interconnect (INT). Although a mesh interconnect is discussed in certain embodiments, other interconnect topologies may be utilized (e.g., ring, star, tree, fully connected mesh, partially connected mesh, etc.).

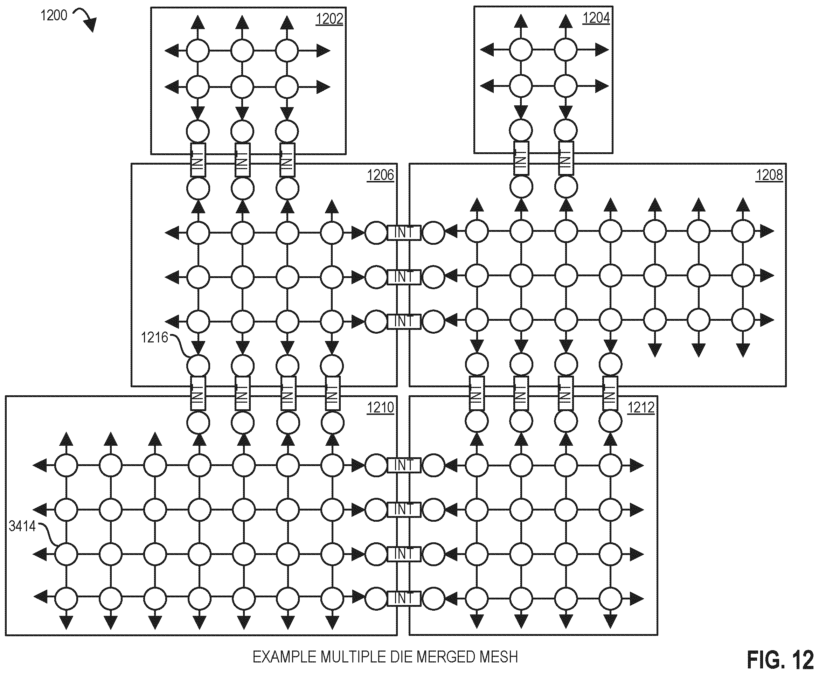

**Figure 12** illustrates a hardware processor 1200 according to embodiments of the disclosure. In the depicted embodiment, dies 1202 and 1204 (e.g., of the same size) are smaller than die 1206, die 1208, die 1210, and die 1212. Die 1206 is depicted as including a different mesh interconnect than die 1208, e.g., having a different number of intersections (e.g., intersection 1214) and/or transceivers (e.g., transceiver 1216). Figure 12 illustrates that certain of a plurality of dies may be different in certain embodiments (e.g., in one embodiment, they are not symmetric). Figure 12 illustrates that a mesh interconnect on a die may be different than another mesh interconnect on a different die in certain embodiments (e.g., in one embodiment, they are not symmetric).

Certain embodiments herein provision coherency resources and mesh transactions. Certain embodiments here provide for a master die controller to discover resources conditions across all dies to build resource capability, resource address table, and/or routing performance bias tables. Certain embodiments of a master controller walk though anticipated possible resources and subtract, e.g., by reading remote fuses or registers and based on successful handshakes. Certain embodiments of a master controller have preprogrammed set of maps to configure the resource tables (e.g., credits), mesh look-up-tables (LUTs), address translations services (e.g., system address map), etc. to allow mesh traversal cross dies. The chosen preprogrammed map may be based on resource identified.

Certain embodiments of an electrical interconnect (e.g., and/or transceiver circuit(s)) between multiple dies provides very high bandwidth matching the bandwidth of on-die integrated (e.g., mesh) interconnect. Certain embodiments of an electrical interconnect (e.g., and/or transceiver circuit(s)) between multiple dies provides (e.g., very) low latency, e.g., which matches or substantially matches the latency of an on-die integrated interconnect. Certain interconnects (e.g., and/or transceiver circuit(s)) herein include communication with the native protocol of each die internal data transport and/or does not require the overhead of packetizing nor serializing the data transmitted or received over an electrical interconnect between dies (e.g., minimizing latency impact for the interconnect). Certain interconnects (e.g., and/or transceiver circuit(s)) herein include bandwidth reduction for communication without error protection as a way to increase data transfer efficiency and reduced latency. Certain interconnects (e.g., and/or transceiver circuit(s)) herein include dynamic transfer rate transitions (e.g., matching on-die communication bus frequency changes) on-the-fly with minimal (e.g., single-digit) clock cycles to update and transition the timing synchronization of an electrical interconnect.

Certain interconnects (e.g., and/or transceiver circuit(s)) herein provide reduced pin count but allow full cross sectional bandwidth (BW) (e.g., clocking rate), such as ¼ pins used with 4x data rate as compared to data frequency within a die, or ½ pins used with 2x data rate as compared to data frequency within a die. Certain interconnects (e.g., and/or transceiver circuit(s)) herein provide reduced pin count but allow selectable bandwidth (BW), such as 2x bandwidth with 4x data rate as compared to data frequency within a die, or 1x bandwidth with 2x data rate as compared to data frequency within a die. Certain interconnects (e.g., and/or transceiver circuit(s)) herein include dynamic and rapid transitions between a first (e.g., 1x) bandwidth and second, different (e.g., 2x) bandwidth as two modes that conditionally provide the optimal choice of benefits in bandwidth performance versus benefits in power savings, reduced penalty in latency caused by additional clock crossings into low jitter clocking domain, and/or reducing the error rate that high performance transfers may have. Certain interconnects (e.g., and/or transceiver circuit(s)) herein provide for dynamic and rapid transitions between a first (e.g., 1x) bandwidth and a second, different (e.g., higher or lower) (e.g., 2x) bandwidth modes. Certain interconnects (e.g., and/or transceiver circuit(s)) herein include traffic flow control circuitry to halt traffic temporarily when transitioning, for example, when transitioning between clocking rates (e.g., 1X, 2X, 4X, etc.) and/or when transitioning between different operating frequencies (e.g., frequency rates).

Certain interconnects (e.g., and/or transceiver circuit(s)) herein provision for separate and independent tuning of receiver, transmitter, and/or clocking circuits for each bandwidth (e.g., clocking rate) and frequency mode on each instantiation and on each die, for example, so as to compensate for within-die and die-to-die process variations as well as temporal temperature and voltage supply variations. Certain interconnects (e.g., and/or transceiver circuit(s)) herein include a communication error detection mechanism (e.g., parity or similar) that allows for proper handling at the processor level (e.g., re-booting, etc.).

Certain embodiments herein provide for an electrical interconnect (e.g., and/or transceiver circuit(s)) that has facilities for boot-time multi-point characterization sweeping across multiple variables for transmitter and receiver circuit parameters with storage for rapid parameter look-up during runtime changes, e.g., changes in clock frequency, voltage level, or clocking rates (e.g., 1X, 2X, 4X, etc.). Certain embodiments herein provide for an electrical interconnect (e.g., and/or transceiver circuit(s)) that provides for periodic refresh of stored transmitter and receiver circuit parameters re-characterization to recapture changed environment and circuit conditions. Certain embodiments of an electrical interconnect (e.g., and/or transceiver circuit(s)) herein provide for rapid processor clock, power, and/or data-rate transitions during critical runtime operations and apply the low running multi-point seeping characterization and parameter recording, e.g., only during Boot time or periods of runtime that are not processor performance sensitive. Certain embodiments of an electrical interconnect (e.g., and/or transceiver circuit(s)) herein provide for die-to-die exchange that optimizes explicit state update (e.g., Rx DLL is locked, Tx PLL is locked, Tx duty cycle corrector (DCC) is locked, etc.) and/or reduces latency from assumption timers. Certain embodiments of an electrical interconnect (e.g., and/or transceiver circuit(s)) herein provide for after the multi-point seeping characterization to be autonomous management within the interconnect circuitry, e.g., that does not need management from firmware, BIOS, and/or drivers.

### APPARATUS AND METHOD FOR SCENARiO-BASED COMPRESSION

In current SoC implementations, various IP blocks communicate over an interconnect fabric which can include on-die fabric links and, in the case of multi-chip packages, die-to-die (D2D) links. A major challenge with D2D implementations is insufficient on-die area or shoreline required for protocol wires. As such, the overall link bandwidth may be lower than desired.

One way to address the problem of insufficient on-die area or shoreline is to use a relatively narrow high-speed interface which transfers inter-die messages in a packetized format. Such packetization is defined, for example, in protocols such as PCIe, Compute Express Link (CXL), and Ultrapath Interconnect (UXI). The same sets of physical wires of the D2D link may be used for all protocol messages, including requests, responses, and data transfers. The packetized protocol defines how the original protocol messages are arranged in a block of raw data lanes, referred to as a "flit".

FIG. 13A illustrates an example of a first die/fabric 1395 comprising a first plurality of fabric endpoints or routers 1391A-E and a second die/fabric 1396 comprising a second plurality of fabric endpoints or routers 1392A-D. The fabric endpoints/routers 1391A-E are coupled over intra-fabric/intra-die links 1395 and the fabric endpoints/routers 1392A-D are coupled over intra-fabric/intra-die links 1396. Inter-fabric/die-to-die (D2D) links 1372 couple a fabric endpoint/router 1391A of the first die/fabric 1395 to a fabric endpoint/router 1392A of the second die/fabric 1396. However, because of the issues mentioned above, the inter-fabric D2D links 1372 may not be capable of supporting a desired bandwidth between die/fabric 1395 and die/fabric 1396.

To address the bandwidth limitations of these inter-fabric/D2D links 1372, embodiments of the invention include message compression and decompression logic 1378 to compress messages prior to transmission and decompress the messages upon receipt, thereby allowing a larger number of messages to be passed for a given physical bandwidth.

**FIG. 13B** illustrates a specific example in which a processor die 1301 includes a D2D interface 1370 which is coupled to a D2D interface 1371 of a peripheral control device 1302 via D2D links 1372. In this example, the processor die 1301 includes a plurality of cores 1310-1311 and a home agent 1352 which couples the cores 1310-1311 to an on-die fabric 1309 to access various on-die components including a cache subsystem 1315, a memory controller 1350 (to access a system memory 1355), a display engine 1342, graphic processing circuitry 1330, tensor/AI circuitry 1334 (e.g., for performing matrix operations), and the D2D interface 1370 (e.g., for inter-die transactions over the D2D links 1372).

The peripheral control die 1302 includes PCIe interfaces 1360, audio circuitry 1362, a boot/security IP block 1364, a storage controller 1366 (to couple to a storage device 1370), a network interface 1368, and a USB interface 1369.

While a specific arrangement of a processor die 1301 and peripheral control die 1302 is illustrated as one example, the underlying principles of the invention are not limited to this specific configuration. Rather, embodiments of the invention may be implemented in any multi-die or multi-fabric data processing device in which inter-die or inter-fabric links are used.

The D2D interfaces 1370-1371 each include compression/decompression circuitry 1378A-B, respectively, for implementing message compression as described herein. In one embodiment, each compression/decompression circuit 1378A-B includes at least one message control register, referred to as a Message Match Control Register (MMCR), for storing constant message fields. In some embodiments, for example, each MMCR is statically programmed with the constant message fields based on a pre-runtime analysis of the expected traffic. Alternatively, or additionally, in certain embodiments, message fields which are transmitted/received multiple times during one or more transactions and/or over a period of time may be identified at runtime, and the MMCRs updated accordingly.

Regardless of how the MMCRs are programmed, a compressed message format is thereby defined in which variable message fields are combined with indications of the constant message fields stored in the MMCRs. For example, the constant message fields within the message may be replaced with bit fields which identify the MMCRs storing the corresponding constant message fields.

In operation, when the transmitter such as D2D interface 1370 detects a match between a message field of a message to transmit and a message field in an MMCR, the corresponding compression/ decompression circuitry 1378A compresses the message by replacing the message field with an indication of a corresponding location in an MMCR (i.e., where a copy of the message field is stored). The compression/decompression circuitry 1378B of the receiving D2D interface 1371, then uses this indication to identify the message field in its corresponding MMCR to reconstruct the packet. The end result is that each link can support provide an increased bandwidth can be provided over with a given link gives value to customer as it enables more extensive usages, e.g., higher I/O BW makes disk scenario like file copy to be faster.

In the particular example shown in **FIG. 13B****,** the D2D interfaces 1370-1371 are used for different types of transactions including IO read requests (memory read requests from the various IO devices that are connected through the peripheral control die 1302) and responses (e.g., data from memory 1355 that is returned from the processor die 1301 to the peripheral control die 1302). In addition, IO write requests including data to be written to memory 1355 may originate from the peripheral control die 1302 and require completion responses from the processor die 1301 to the peripheral control die 1302. Address translation requests may also be generated to serve the IO read and write requests. As another example, memory-mapped IO (MMIO) read and write requests generated by the processor die 1301 target devices that are connected through the peripheral control die 1302.

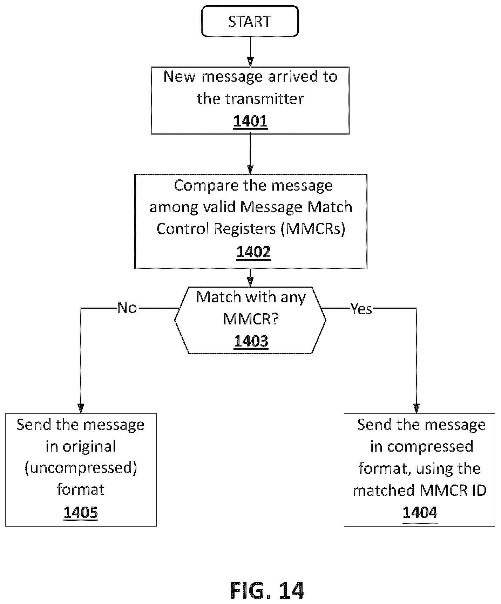

One embodiment of a method for performing compression (e.g., by a transmitting D2D interface) is illustrated in FIG. 14. At 1401, a new message to be transmitted arrives and, at 1402, the message fields are compared to fields stored in one or more MMCRs. In this embodiment, the transmitting D2D interface and receiving D2D interface maintain a synchronized set of MMCR registers by updating their respective MMCR registers in response to the same detected messaging events.

At 1403, if the transmitter D2D interface detects a match of a message field with any MMCR, then the message field is replaced with a corresponding MMCR identifier (ID), which identifies a particular MMCR and/or a particular location within the MMCR. The transmitter D2D interface may also set a bit to indicate that at least one message field is compressed. If there is no match at 1403, then the message is transmitted uncompressed.

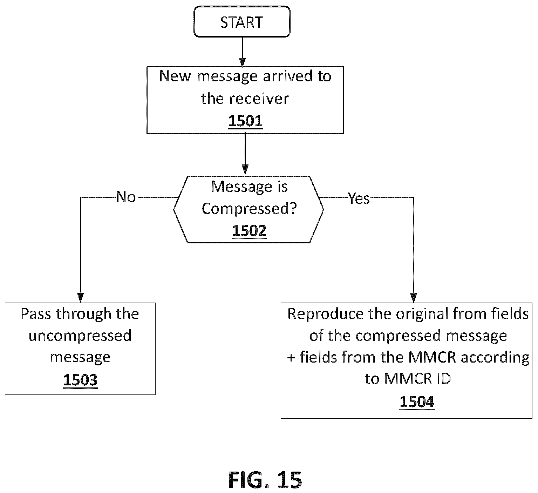

One embodiment of a method for performing decompression (e.g., by a receiving D2D interface) is illustrated in FIG. 15. At 1501, the message arrives at the receiving D2D interface which determines if the message is compressed at 1502 (e.g., by reading a compression bit). If so, then at 1504 the receiving D2D interface reproduces the original message using the fields of the compressed message and the fields from the MMCR(s) identified by MMCR ID(s). If not, then the uncompressed message is passed through to its destination at 1503.

Thus, scenario-based compression reduces the amount of transferred data by sending only portions of the message in combination with MMCR ID(s) to identify certain fields stored in the receiving D2D interface's MMCR registers.

FIG. 16 illustrates a set of D2D operations for one embodiment of a read transaction and a write transaction. A read from IO system fabric (IOSF) 1601 operation initiated by the peripheral control die (PCD) 1302 crosses the D2D links 1372 via D2D interfaces 1371-1372 to reach the home agent 1352. In response, the home agent 1352 generates a read forward command to the memory controller 1350 which indicates a memory address from which to read data. The memory controller 1350 performs the read from the system memory (not shown) and responds to the PCD 1302 with two messages (MemData) each of which include a header and a 32B chunk of data read from memory.

A write from IOSF 1602 initiated by the PCD 1302 crosses the D2D links 1372 via D2D interfaces 1371-1372 to reach the home agent 1352, which responds with an acknowledgement (GO-E). The PCD 1302 then generates two messages (MemWr), each of which include a header and a 32B chunk if data to be written to memory. In response, the home agent 1352 generates a write operation (MemWr) to the memory controller 1350, which performs the write to system memory and responds with a completion message, which the home agent 1352 forwards to the PCD 1302.

In some embodiments, each D2D interface subdivides data to be transmitted into units of data transfer referred to as "slots." For example, a 16-Byte slot can be used either to transfer a quarter of a cacheline (assuming a cacheline of 64B) or as a "Header Slot", which includes a combination of Request, Response and Data Header information used in messages of a transaction. Some embodiments of the compression/decompression circuitry 1378A-B implements scenario-based compression as described herein to reduce the number of header slots required, which are typically duplicated across messages of a given transaction.

Without any compression or optimization, 7 slots would be needed for the read and write transactions shown in **FIG. 16** (4 data slots in each direction + 3 header slots in the up direction from the UP direction (i.e., from the PCD to the processor die). The effective link bandwidth (the portion of the bandwidth that is used for data transfer) is 4/7 of the total link bandwidth. Thus, if the total link bandwidth is 16 GB/s/direction, the effective bandwidth is 9.14 GB/s/direction.

In contrast, using the embodiments of scenario-based compression as described herein, 6 slots are needed (4 data slots in each direction + 2 header slots in the UP direction, i.e., from the PCD to the processor die). The effective link bandwidth is 4/6 of the total link bandwidth, or (4/6) * (16 GB/s/direction) = 10.67 GB/s/direction, an overall bandwidth improvement of 17%.

In some embodiments, each type of transaction can be optimized with a corresponding 32b MMCR register in each die or fabric. By way of example, and not limitation, to achieve the 17% bandwidth increase in FIG. 16, six 32b MMCR registers can be used, one for each D2D message: RdCurr (request), MemData (data header), SpecFlOwn (request), GO-E (response), MemWr (data header), and Cmp (response).

In some embodiments, the MMCR register lookup is performed in parallel with other bandwidth optimizations and compression techniques. Depending on the implementation, scenario-based compression does not add latency or may add up to 2 cycles (one in the transmitter D2D interface to compress, and one in the receiver D2D interface to decompress).

These embodiments can also provide significant power reduction. For example, in D2D links which can transition between higher power active data transfer states and lower power active idle states, the number of active cycles drops from 13 to 11, which is a 15% reduction in active power.

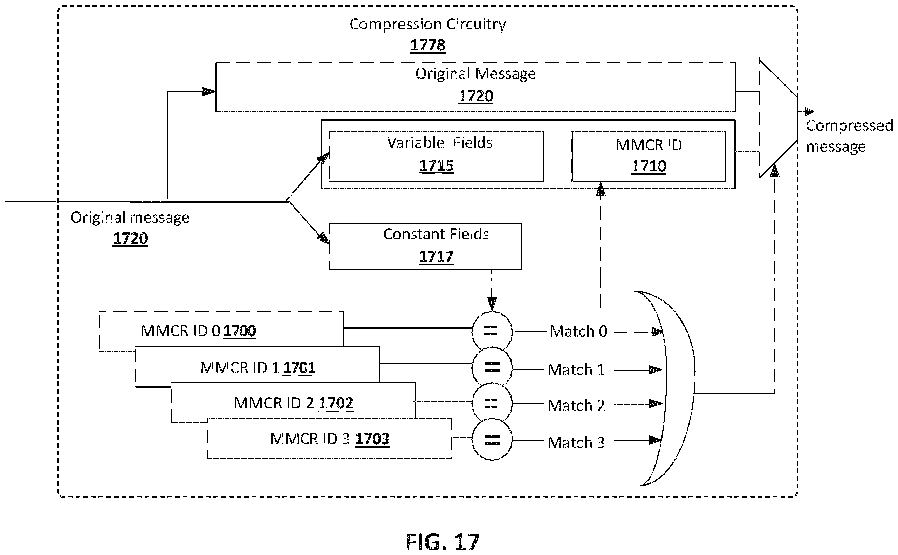

FIG. 17 illustrates a compression circuit 1778 for performing message compression in accordance with embodiments of the invention. The illustrated compression circuit 1778 may be included in the compression/decompression circuitry 1378A-B to perform message compression as described above.

The illustrated embodiment includes four MMCR registers 1700-1703, each uniquely identified with a different MMCR identifier (ID). Constant fields 1717 extracted from the original message 1720 are compared against the fields in the MMCR registers 1700-1703. If a match is detected, the corresponding MMCR ID 1710 is inserted in the message in place of the corresponding constant fields 1717, in combination with the variable fields 1715. In some embodiments, a data field location may also be added to the message to identify a location within the MMCR register which stores the constant field. As mentioned, a "constant" message field is a message field which is used in multiple messages (e.g., such as the header information associated with a transaction). If no constant fields are identified in the MMCRs, then the original message 1720 is transmitted without compression. An MMCR 1700-1703 may be updated with one or more constant fields 1717 to be available for compressing subsequent messages.

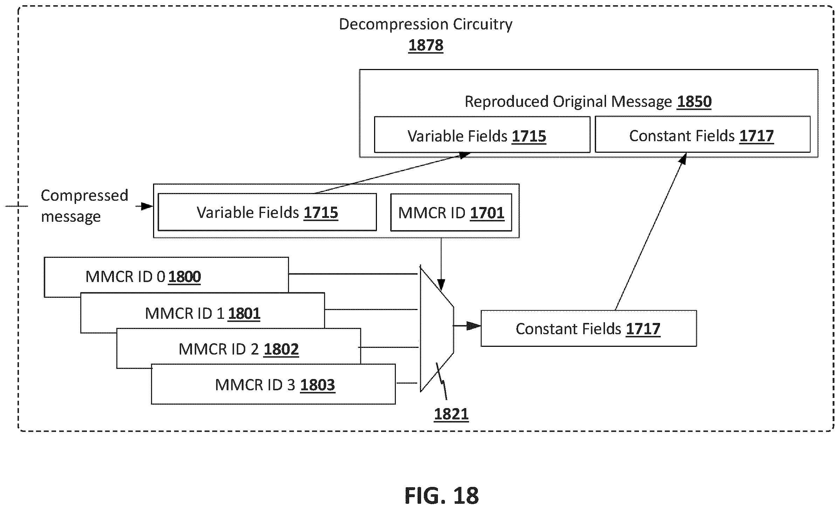

FIG. 18 illustrates a decompression circuit 1878 for performing message decompression in accordance with embodiments of the invention. The illustrated decompression circuit 1878 may be included in the compression/decompression circuitry 1378A-B to perform message decompression as described above.

The decompression circuitry 1878 includes four MMCR registers 1800-1803 corresponding to the four MMCR registers 1700-1703 of the compression circuitry 1778 and associated with the same MMCR ID as the MMCR registers 1700-1703. The decompression circuitry uses the MMCR ID 1701 inserted by the compression circuitry 1778 to identify a corresponding constant field 1717 in an MMCR 1800-1803 (e.g., via a selection MUX 1821 or similar logic). It reconstructs the original message 1850 by inserting the constant fields 1717 in place of corresponding MMCR IDs 1701. As indicated, variable fields are copied to the original message 1850 unmodified.

To further illustrate the operation of certain embodiments of the invention, examples are provided below using CXL.mem messages. It should be noted, however, that the underlying principles of the invention are not limited to any particular message types.

The left-hand portion of the table below includes the original field and their sizes as defined in the CXL spec. The right-hand portion sorts the fields (or part of fields) to bits that must be sent over the link (and therefore are included on the compressed message format) and bits that can be saved in MMCR register (so they are not included in the compressed message).

**TABLE A**

| **Original spec (definition of full message format)** | | | **Using scenario-based compression** | | |
|---|---|---|---|---|---|
| *Message* | *Field* | *Size in Spec (bits)* | *Bits to save in registers* | *Compressed message bits* | *Explanation* |
| | Valid | 1 | 1 | 0 | A message is not sent unless it's valid |
| | MemOpcode | 4 | 4 | 0 | Opcode and other request attributes are constant in a high % of requests |
| | SnpType | 3 | 3 | 0 | |
| | MetaField | 2 | 2 | 0 | |
| | MetaValue | 2 | 2 | 0 | |
| | Tag | 16 | 8 | 8 | The IPs that send this message use only a 8-bits tag, the MSB is zero (or other constant) |
| CXL.mem M2S Req Channel (PBR mode) | Address[51:6] | 46 | 0 | 46 | Different for each request |
| | SPID | 12 | 10 | 2 | This type of message is always sent from a group of 4 IPs with a constant consecutive Port ID |
| | DPID | 12 | 11 | 1 | This type of message is always sent from a group of 2 IPs with a constant consecutive Port ID |
| | RSVD | 20 | 0 | 0 | Reserved fields are always 0 |
| | TC | 2 | 0 | 2 | Different for each request |
| | Total | 120 | 41 | 59 | |
| | Valid | 1 | 1 | 0 | A message is not sent unless it's valid |
| | Opcode | 3 | 3 | 0 | Opcode and other request attributes are constant in a high % of requests |
| | MetaField | 2 | 2 | 0 | |
| CXL.mem S2M DRS Channel (PBR mode) | MetaValue | 2 | 2 | 0 | |
| | Tag | 16 | 8 | 8 | The IPs that receive this response message use only a 8-bits tag, the MSB is zero (or other constant) |
| | Posion | 1 | 1 | 0 | Poison is a rare case, so the register programs it as 0. If a poison occurs, message will not be compressed |
| | DevLoad | 2 | 0 | 2 | Depends on current fabric status |
| | DPID | 12 | 10 | 2 | This type of message is always sent to a group of 4 IPs with a constant consecutive Port ID |
| | RSVD | 9 | 0 | 0 | Reserved fields are always 0 |
| | Total | 48 | 27 | 12 | |

In one example, certain MMCRs may be used only by certain types of opcodes and attributes (e.g., SnpType, MetaField, MetaValue in the CXL.mem example). When a particular opcode type is identified, the opcode and attributes are saved in the corresponding MMCR and not sent with the compressed message. The receiver will then use its corresponding MMCR to determine the opcode and attributes.

In some embodiments, a field that indicates a rare condition (that may or may not occur) may be saved in an MMCR, such as a poison bit. In the above example, the poison value that is saved in the MMCR indicates that the poison circumstances did not occur. In the relatively rare case where a poison does occur, the message will not be compressed (and will be sent in the original format).

Some fields can be partially saved in an MMCR, and only the portion of the field which is not saved is included in the compressed message. For example, as indicated in Table A, the source port ID (SPID) and destination port ID (DPID) (source/destination PortID) are 12-bits in the original message. If it is known that the message to be compressed is always sent from or to a small group of agents that share the same PortID prefix, then the prefix value can be saved in an MMCR register. By way of example, and not limitation, a memory access request may always be sent to the Home Agent and an address translation request may always be sent to an IOMMU agent.

Continuing with the same example, new message formats are defined in some embodiments. This may include all the variable fields of the original message, and a new field, MMCR ID, that identifies the MMCR that was used to compress this message. Table B provides an example for a CXL.mem message.

**TABLE B**

| **Message** | **Field** | **Size** |
|---|---|---|
| Compressed M2S Req | Tag[7:0] | 8 |
| | Address[51:6] | 46 |
| | SPID[1:0] | 2 |
| | DPID[0] | 1 |
| | TC | 2 |
| | MMCR ID | 3 |
| | **Total** | **62** |
| Compressed S2M DRS | Tag[7:0] | 8 |
| | DevLoad | 2 |
| | DPID[1:0] | 2 |
| | MMCR ID | 3 |
| | **Total** | **15** |

And the complementary MMCR, that includes the "constant" message fields, is defined like this:

**TABLE C**

| **Register** | **Field** | **bit range** |
|---|---|---|
| MMCR_Compressed _M2S_Req | Valid | [0:0] |
| | MemOpcode | [4:1] |
| | SnpType | [7:5] |
| | MetaField | [9:8] |
| | MetaValue | [11:10] |
| | Tag[15:8] | ]19:12] |
| | SPID[11:10] | [21:20] |
| | DPID[11] | [22:22] |
| MMCR_Compressed _S2M_DRS | Valid | [0:0] |
| | Opcode | [3:1] |
| | MetaField | [5:4] |
| | MetaValue | [7:6] |
| | Tag | [15:8] |
| | Posion | [16:16] |
| | DPID | [26:17] |

### Exemplary Core Architectures

In-order and out-of-order core block diagram

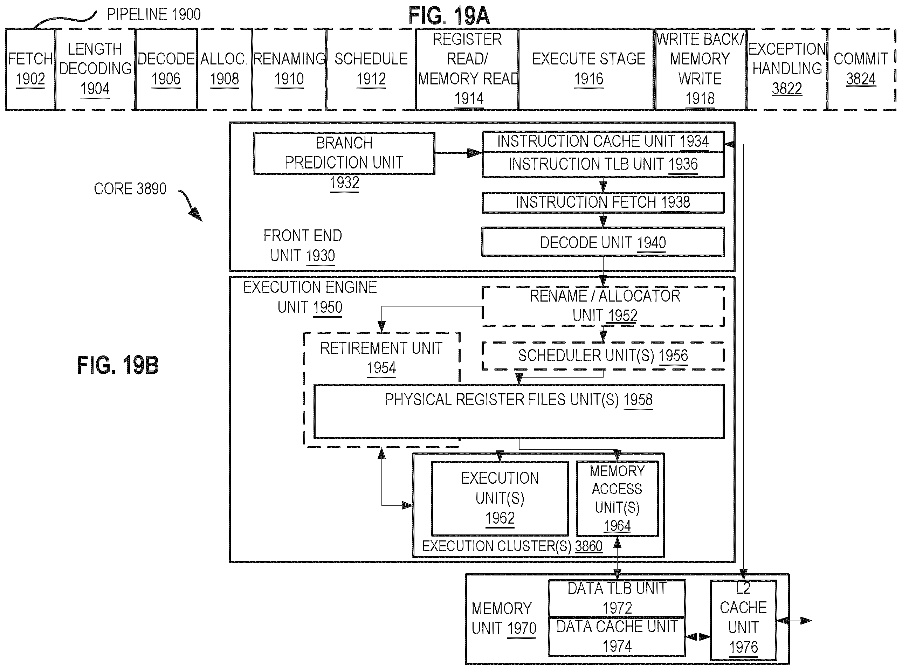

**Figure 19A** is a block diagram illustrating both an exemplary in-order pipeline and an exemplary register renaming, out-of-order issue/execution pipeline according to embodiments of the disclosure. Figure 19B is a block diagram illustrating both an exemplary embodiment of an in-order architecture core and an exemplary register renaming, out-of-order issue/execution architecture core to be included in a processor according to embodiments of the disclosure. The solid lined boxes in **Figures 19A-B** illustrate the in-order pipeline and in-order core, while the optional addition of the dashed lined boxes illustrates the register renaming, out-of-order issue/execution pipeline and core. Given that the in-order aspect is a subset of the out-of-order aspect, the out-of-order aspect will be described.

In **Figure 19A****,** a processor pipeline 1900 includes a fetch stage 1902, a length decode stage 1904, a decode stage 1906, an allocation stage 1908, a renaming stage 1910, a scheduling (also known as a dispatch or issue) stage 1912, a register read/memory read stage 1914, an execute stage 1916, a write back/memory write stage 1918, an exception handling stage 1922, and a commit stage 1924.

**Figure 19B** shows processor core 1990 including a front end unit 1930 coupled to an execution engine unit 1950, and both are coupled to a memory unit 1970. The core 1990 may be a reduced instruction set computing (RISC) core, a complex instruction set computing (CISC) core, a very long instruction word (VLIW) core, or a hybrid or alternative core type. As yet another option, the core 1990 may be a special-purpose core, such as, for example, a network or communication core, compression engine, coprocessor core, general purpose computing graphics processing unit (GPGPU) core, graphics core, or the like.

The front end unit 1930 includes a branch prediction unit 1932 coupled to an instruction cache unit 1934, which is coupled to an instruction translation lookaside buffer (TLB) 1936, which is coupled to an instruction fetch unit 1938, which is coupled to a decode unit 1940. The decode unit 1940 (or decoder or decoder unit) may decode instructions (e.g., macro-instructions), and generate as an output one or more micro-operations, micro-code entry points, micro-instructions, other instructions, or other control signals, which are decoded from, or which otherwise reflect, or are derived from, the original instructions. The decode unit 1940 may be implemented using various different mechanisms. Examples of suitable mechanisms include, but are not limited to, look-up tables, hardware implementations, programmable logic arrays (PLAs), microcode read only memories (ROMs), etc. In one embodiment, the core 1990 includes a microcode ROM or other medium that stores microcode for certain macroinstructions (e.g., in decode unit 1940 or otherwise within the front end unit 1930). The decode unit 1940 is coupled to a rename/allocator unit 1952 in the execution engine unit 1950.

The execution engine unit 1950 includes the rename/allocator unit 1952 coupled to a retirement unit 1954 and a set of one or more scheduler unit(s) 1956. The scheduler unit(s) 1956 represents any number of different schedulers, including reservations stations, central instruction window, etc. The scheduler unit(s) 1956 is coupled to the physical register file(s) unit(s) 1958. Each of the physical register file(s) units 1958 represents one or more physical register files, different ones of which store one or more different data types, such as scalar integer, scalar floating point, packed integer, packed floating point, vector integer, vector floating point, status (e.g., an instruction pointer that is the address of the next instruction to be executed), etc. In one embodiment, the physical register file(s) unit 1958 comprises a vector registers unit, a write mask registers unit, and a scalar registers unit. These register units may provide architectural vector registers, vector mask registers, and general purpose registers. The physical register file(s) unit(s) 1958 is overlapped by the retirement unit 1954 to illustrate various ways in which register renaming and out-of-order execution may be implemented (e.g., using a reorder buffer(s) and a retirement register file(s); using a future file(s), a history buffer(s), and a retirement register file(s); using a register maps and a pool of registers; etc.). The retirement unit 1954 and the physical register file(s) unit(s) 1958 are coupled to the execution cluster(s) 1960. The execution cluster(s) 1960 includes a set of one or more execution units 1962 and a set of one or more memory access units 1964. The execution units 1962 may perform various operations (e.g., shifts, addition, subtraction, multiplication) and on various types of data (e.g., scalar floating point, packed integer, packed floating point, vector integer, vector floating point). While some embodiments may include a number of execution units dedicated to specific functions or sets of functions, other embodiments may include only one execution unit or multiple execution units that all perform all functions. The scheduler unit(s) 1956, physical register file(s) unit(s) 1958, and execution cluster(s) 1960 are shown as being possibly plural because certain embodiments create separate pipelines for certain types of data/operations (e.g., a scalar integer pipeline, a scalar floating point/packed integer/packed floating point/vector integer/vector floating point pipeline, and/or a memory access pipeline that each have their own scheduler unit, physical register file(s) unit, and/or execution cluster - and in the case of a separate memory access pipeline, certain embodiments are implemented in which only the execution cluster of this pipeline has the memory access unit(s) 1964). It should also be understood that where separate pipelines are used, one or more of these pipelines may be out-of-order issue/execution and the rest in-order.

The set of memory access units 1964 is coupled to the memory unit 1970, which includes a data TLB unit 1972 coupled to a data cache unit 1974 coupled to a level 2 (L2) cache unit 1976. In one exemplary embodiment, the memory access units 1964 may include a load unit, a store address unit, and a store data unit, each of which is coupled to the data TLB unit 1972 in the memory unit 1970. The instruction cache unit 1934 is further coupled to a level 2 (L2) cache unit 1976 in the memory unit 1970. The L2 cache unit 1976 is coupled to one or more other levels of cache and eventually to a main memory.

By way of example, the exemplary register renaming, out-of-order issue/execution core architecture may implement the pipeline 1900 as follows: 1) the instruction fetch 1938 performs the fetch and length decoding stages 1902 and 1904; 2) the decode unit 1940 performs the decode stage 1906; 3) the rename/allocator unit 1952 performs the allocation stage 1908 and renaming stage 1910; 4) the scheduler unit(s) 1956 performs the schedule stage 1912; 5) the physical register file(s) unit(s) 1958 and the memory unit 1970 perform the register read/memory read stage 1914; the execution cluster 1960 perform the execute stage 1916; 6) the memory unit 1970 and the physical register file(s) unit(s) 1958 perform the write back/memory write stage 1918; 7) various units may be involved in the exception handling stage 1922; and 8) the retirement unit 1954 and the physical register file(s) unit(s) 1958 perform the commit stage 1924.

The core 1990 may support one or more instructions sets (e.g., the x86 instruction set (with some extensions that have been added with newer versions); the MIPS instruction set of MIPS Technologies of Sunnyvale, CA; the ARM instruction set (with optional additional extensions such as NEON) of ARM Holdings of Sunnyvale, CA), including the instruction(s) described herein. In one embodiment, the core 1990 includes logic to support a packed data instruction set extension (e.g., AVX1, AVX2), thereby allowing the operations used by many multimedia applications to be performed using packed data.

It should be understood that the core may support multithreading (executing two or more parallel sets of operations or threads), and may do so in a variety of ways including time sliced multithreading, simultaneous multithreading (where a single physical core provides a logical core for each of the threads that physical core is simultaneously multithreading), or a combination thereof (e.g., time sliced fetching and decoding and simultaneous multithreading thereafter such as in the Intel^{®} Hyperthreading technology).

While register renaming is described in the context of out-of-order execution, it should be understood that register renaming may be used in an in-order architecture. While the illustrated embodiment of the processor also includes separate instruction and data cache units 1934/1974 and a shared L2 cache unit 1976, alternative embodiments may have a single internal cache for both instructions and data, such as, for example, a Level 1 (L1) internal cache, or multiple levels of internal cache. In some embodiments, the system may include a combination of an internal cache and an external cache that is external to the core and/or the processor. Alternatively, all of the cache may be external to the core and/or the processor.

### Specific Exemplary In-Order Core Architecture

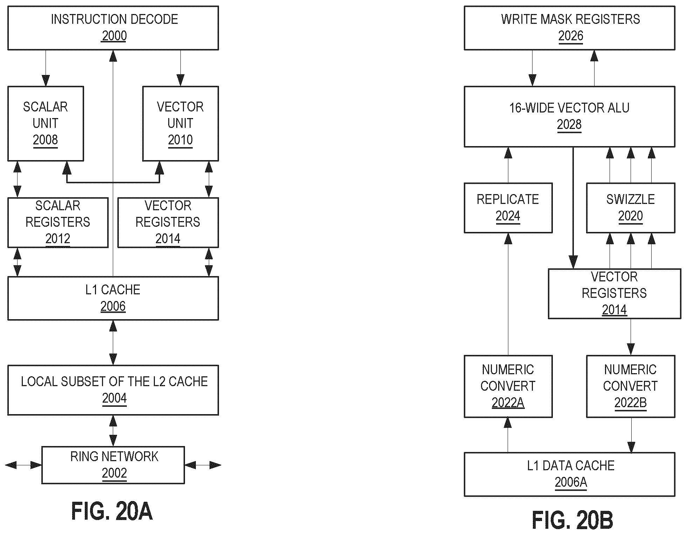

**Figures 20A-B** illustrate a block diagram of a more specific exemplary in-order core architecture, which core would be one of several logic blocks (including other cores of the same type and/or different types) in a chip. The logic blocks communicate through a high-bandwidth interconnect network (e.g., a ring network) with some fixed function logic, memory I/O interfaces, and other necessary I/O logic, depending on the application.

**Figure 20A** is a block diagram of a single processor core, along with its connection to the on-die interconnect network 2002 and with its local subset of the Level 2 (L2) cache 2004, according to embodiments of the disclosure. In one embodiment, an instruction decode unit 2000 supports the x86 instruction set with a packed data instruction set extension. An L1 cache 2006 allows low-latency accesses to cache memory into the scalar and vector units. While in one embodiment (to simplify the design), a scalar unit 2008 and a vector unit 2010 use separate register sets (respectively, scalar registers 2012 and vector registers 2014) and data transferred between them is written to memory and then read back in from a level 1 (L1) cache 2006, alternative embodiments of the disclosure may use a different approach (e.g., use a single register set or include a communication path that allow data to be transferred between the two register files without being written and read back).

The local subset of the L2 cache 2004 is part of a global L2 cache that is divided into separate local subsets, one per processor core. Each processor core has a direct access path to its own local subset of the L2 cache 2004. Data read by a processor core is stored in its L2 cache subset 2004 and can be accessed quickly, in parallel with other processor cores accessing their own local L2 cache subsets. Data written by a processor core is stored in its own L2 cache subset 2004 and is flushed from other subsets, if necessary. The ring network ensures coherency for shared data. The ring network is bi-directional to allow agents such as processor cores, L2 caches and other logic blocks to communicate with each other within the chip. Each ring data-path is 1012-bits wide per direction.

**Figure 20B** is an expanded view of part of the processor core in **Figure 20A** according to embodiments of the disclosure. **Figure 20B** includes an L1 data cache 2006A part of the L1 cache 2004, as well as more detail regarding the vector unit 2010 and the vector registers 2014. Specifically, the vector unit 2010 is a 16-wide vector processing unit (VPU) (see the 16-wide ALU 2028), which executes one or more of integer, single-precision float, and double-precision float instructions. The VPU supports swizzling the register inputs with swizzle unit 2020, numeric conversion with numeric convert units 2022A-B, and replication with replication unit 2024 on the memory input. Write mask registers 2026 allow predicating resulting vector writes.

**Figure 21** is a block diagram of a processor 2100 that may have more than one core, may have an integrated memory controller, and may have integrated graphics according to embodiments of the disclosure. The solid lined boxes in **Figure 21** illustrate a processor 2100 with a single core 2102A, a system agent 2110, a set of one or more bus controller units 2116, while the optional addition of the dashed lined boxes illustrates an alternative processor 2100 with multiple cores 2102A-N, a set of one or more integrated memory controller unit(s) 2114 in the system agent unit 2110, and special purpose logic 2108.

Thus, different implementations of the processor 2100 may include: 1) a CPU with the special purpose logic 2108 being integrated graphics and/or scientific (throughput) logic (which may include one or more cores), and the cores 2102A-N being one or more general purpose cores (e.g., general purpose in-order cores, general purpose out-of-order cores, a combination of the two); 2) a coprocessor with the cores 2102A-N being a large number of special purpose cores intended primarily for graphics and/or scientific (throughput); and 3) a coprocessor with the cores 2102A-N being a large number of general purpose in-order cores. Thus, the processor 2100 may be a general-purpose processor, coprocessor or special-purpose processor, such as, for example, a network or communication processor, compression engine, graphics processor, GPGPU (general purpose graphics processing unit), a high-throughput many integrated core (MIC) coprocessor (including 30 or more cores), embedded processor, or the like. The processor may be implemented on one or more chips. The processor 2100 may be a part of and/or may be implemented on one or more substrates using any of a number of process technologies, such as, for example, BiCMOS, CMOS, or NMOS.

The memory hierarchy includes one or more levels of cache within the cores, a set or one or more shared cache units 2106, and external memory (not shown) coupled to the set of integrated memory controller units 2114. The set of shared cache units 2106 may include one or more mid-level caches, such as level 2 (L2), level 3 (L3), level 4 (L4), or other levels of cache, a last level cache (LLC), and/or combinations thereof. While in one embodiment a ring based interconnect unit 2112 interconnects the integrated graphics logic 2108, the set of shared cache units 2106, and the system agent unit 2110/integrated memory controller unit(s) 2114, alternative embodiments may use any number of well-known techniques for interconnecting such units. In one embodiment, coherency is maintained between one or more cache units 2106 and cores 2102-A-N.

In some embodiments, one or more of the cores 2102A-N are capable of multi-threading. The system agent 2110 includes those components coordinating and operating cores 2102A-N. The system agent unit 2110 may include for example a power control unit (PCU) and a display unit. The PCU may be or include logic and components needed for regulating the power state of the cores 2102A-N and the integrated graphics logic 2108. The display unit is for driving one or more externally connected displays.

The cores 2102A-N may be homogenous or heterogeneous in terms of architecture instruction set; that is, two or more of the cores 2102A-N may be capable of execution the same instruction set, while others may be capable of executing only a subset of that instruction set or a different instruction set.

### Exemplary Computer Architectures

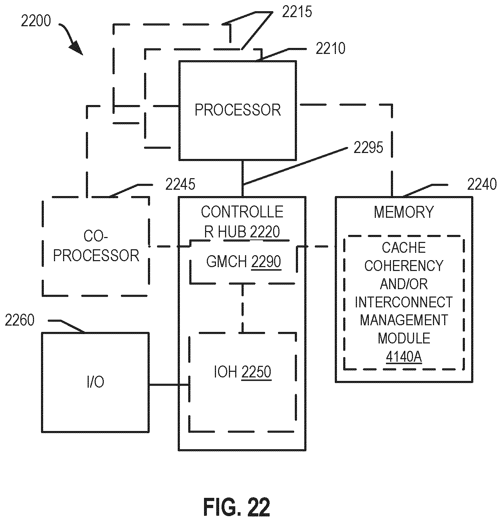

**Figures 22-25** are block diagrams of exemplary computer architectures. Other system designs and configurations known in the arts for laptops, desktops, handheld PCs, personal digital assistants, engineering workstations, servers, network devices, network hubs, switches, embedded processors, digital signal processors (DSPs), graphics devices, video game devices, set-top boxes, micro controllers, cell phones, portable media players, hand held devices, and various other electronic devices, are also suitable. In general, a huge variety of systems or electronic devices capable of incorporating a processor and/or other execution logic as disclosed herein are generally suitable.

Referring now to **Figure 22****,** shown is a block diagram of a system 2200 in accordance with one embodiment of the present disclosure. The system 2200 may include one or more processors 2210, 2215, which are coupled to a controller hub 2220. In one embodiment the controller hub 2220 includes a graphics memory controller hub (GMCH) 2290 and an Input/Output Hub (IOH) 2250 (which may be on separate chips); the GMCH 2290 includes memory and graphics controllers to which are coupled memory 2240 and a coprocessor 2245; the IOH 2250 is couples input/output (I/O) devices 2260 to the GMCH 2290. Alternatively, one or both of the memory and graphics controllers are integrated within the processor (as described herein), the memory 2240 and the coprocessor 2245 are coupled directly to the processor 2210, and the controller hub 2220 in a single chip with the IOH 2250. Memory 2240 may include a cache coherency and/or interconnect management module 2240A, for example, to store code that when executed causes a processor to perform any method of this disclosure.

The optional nature of additional processors 2215 is denoted in Figure 22 with broken lines. Each processor 2210, 2215 may include one or more of the processing cores described herein and may be some version of the processor 4000.

The memory 2240 may be, for example, dynamic random access memory (DRAM), phase change memory (PCM), or a combination of the two. For at least one embodiment, the controller hub 2220 communicates with the processor(s) 2210, 2215 via a multi-drop bus, such as a frontside bus (FSB), point-to-point interface such as QuickPath Interconnect (QPI), or similar connection 2295.

In one embodiment, the coprocessor 2245 is a special-purpose processor, such as, for example, a high-throughput MIC processor, a network or communication processor, compression engine, graphics processor, GPGPU, embedded processor, or the like. In one embodiment, controller hub 2220 may include an integrated graphics accelerator.

There can be a variety of differences between the physical resources 2210, 2215 in terms of a spectrum of metrics of merit including architectural, microarchitectural, thermal, power consumption characteristics, and the like.

In one embodiment, the processor 2210 executes instructions that control data processing operations of a general type. Embedded within the instructions may be coprocessor instructions. The processor 2210 recognizes these coprocessor instructions as being of a type that should be executed by the attached coprocessor 2245. Accordingly, the processor 2210 issues these coprocessor instructions (or control signals representing coprocessor instructions) on a coprocessor bus or other interconnect, to coprocessor 2245. Coprocessor(s) 2245 accept and execute the received coprocessor instructions.

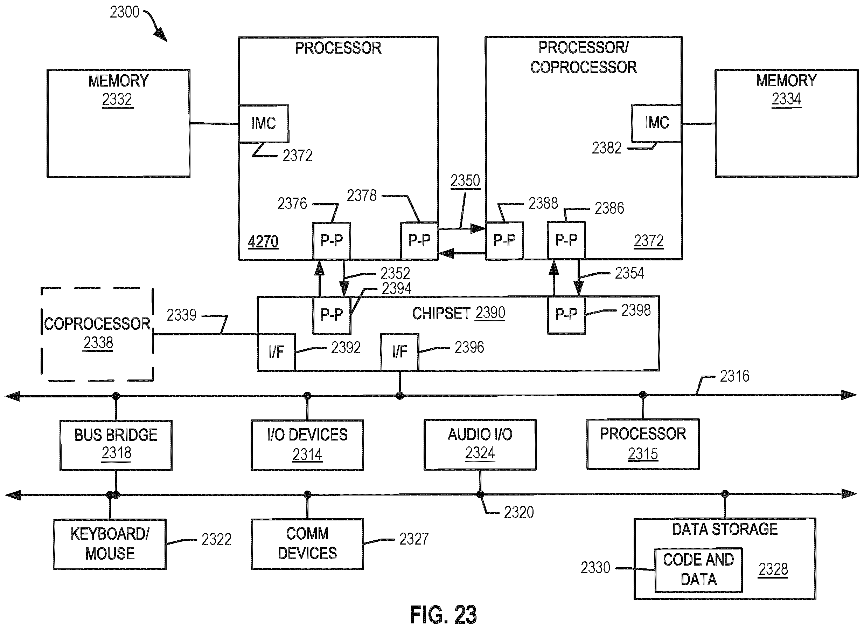

Referring now to **Figure 23****,** shown is a block diagram of a first more specific exemplary system 2300 in accordance with an embodiment of the present disclosure. As shown in **Figure 23****,** multiprocessor system 2300 is a point-to-point interconnect system, and includes a first processor 2370 and a second processor 2380 coupled via a point-to-point interconnect 2350. Each of processors 2370 and 2380 may be some version of the processor 2100. In one embodiment of the disclosure, processors 2370 and 2380 are respectively processors 2110 and 2115, while coprocessor 2338 is coprocessor 2145. In another embodiment, processors 2370 and 2380 are respectively processor 2110 coprocessor 2145.

Processors 2370 and 2380 are shown including integrated memory controller (IMC) units 2372 and 2382, respectively. Processor 2370 also includes as part of its bus controller units point-to-point (P-P) interfaces 2376 and 2378; similarly, second processor 2380 includes P-P interfaces 2386 and 2388. Processors 2370, 2380 may exchange information via a point-to-point (P-P) interface 2350 using P-P interface circuits 2378, 2388. As shown in **Figure 23****,** IMCs 2372 and 2382 couple the processors to respective memories, namely a memory 2332 and a memory 2334, which may be portions of main memory locally attached to the respective processors.

Processors 2370, 2380 may each exchange information with a chipset 2390 via individual P-P interfaces 2352, 2354 using point to point interface circuits 2376, 2394, 2386, 2398. Chipset 2390 may optionally exchange information with the coprocessor 2338 via a high-performance interface 2339. In one embodiment, the coprocessor 2338 is a special-purpose processor, such as, for example, a high-throughput MIC processor, a network or communication processor, compression engine, graphics processor, GPGPU, embedded processor, or the like.

A shared cache (not shown) may be included in either processor or outside of both processors, yet connected with the processors via P-P interconnect, such that either or both processors' local cache information may be stored in the shared cache if a processor is placed into a low power mode.

Chipset 2390 may be coupled to a first bus 2316 via an interface 2396. In one embodiment, first bus 2316 may be a Peripheral Component Interconnect (PCI) bus, or a bus such as a PCI Express bus or another third generation I/O interconnect bus, although the scope of the present disclosure is not so limited.

As shown in **Figure 23****,** various I/O devices 2314 may be coupled to first bus 2316, along with a bus bridge 2318 which couples first bus 2316 to a second bus 2320. In one embodiment, one or more additional processor(s) 2315, such as coprocessors, high-throughput MIC processors, GPGPU's, accelerators (such as, e.g., graphics accelerators or digital signal processing (DSP) units), field programmable gate arrays, or any other processor, are coupled to first bus 2316. In one embodiment, second bus 2320 may be a low pin count (LPC) bus. Various devices may be coupled to a second bus 2320 including, for example, a keyboard and/or mouse 2322, communication devices 2327 and a storage unit 2328 such as a disk drive or other mass storage device which may include instructions/code and data 2330, in one embodiment. Further, an audio I/O 2324 may be coupled to the second bus 2320. Note that other architectures are possible. For example, instead of the point-to-point architecture of **Figure 23****,** a system may implement a multi-drop bus or other such architecture.

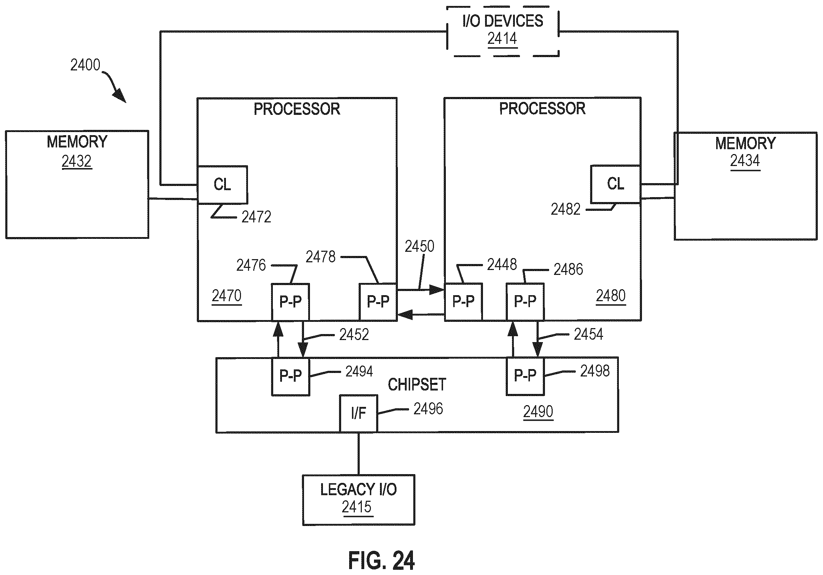

Referring now to **Figure 24****,** shown is a block diagram of a second more specific exemplary system 2400 in accordance with an embodiment of the present disclosure. Like elements in **Figures 23** and **24** bear like reference numerals, and certain aspects of **Figure 23** have been omitted from **Figure 24** in order to avoid obscuring other aspects of **Figure 24****.**

**Figure 24** illustrates that the processors 2370, 2380 may include integrated memory and I/O control logic ("CL") 2372 and 2382, respectively. Thus, the CL 2372, 2382 include integrated memory controller units and include I/O control logic. **Figure 24** illustrates that not only are the memories 2332, 2334 coupled to the CL 2372, 2382, but also that I/O devices 2414 are also coupled to the control logic 2372, 2382. Legacy I/O devices 2415 are coupled to the chipset 2390.

Referring now to **Figure 25****,** shown is a block diagram of a SoC 2500 in accordance with an embodiment of the present disclosure. Similar elements in **Figure 21** bear like reference numerals. Also, dashed lined boxes are optional features on more advanced SoCs. In **Figure 25****,** an interconnect unit(s) 2502 is coupled to: an application processor 2510 which includes a set of one or more cores 202A-N and shared cache unit(s) 2106; a system agent unit 2110; a bus controller unit(s) 2116; an integrated memory controller unit(s) 2114; a set or one or more coprocessors 2520 which may include integrated graphics logic, an image processor, an audio processor, and a video processor; an static random access memory (SRAM) unit 2530; a direct memory access (DMA) unit 2532; and a display unit 2540 for coupling to one or more external displays. In one embodiment, the coprocessor(s) 2520 include a special-purpose processor, such as, for example, a network or communication processor, compression engine, GPGPU, a high-throughput MIC processor, embedded processor, or the like.

In one embodiment, the processor 2210 executes instructions that control data processing operations of a general type. Embedded within the instructions may be coprocessor instructions. The processor 2210 recognizes these coprocessor instructions as being of a type that should be executed by the attached coprocessor 2245. Accordingly, the processor 2210 issues these coprocessor instructions (or control signals representing coprocessor instructions) on a coprocessor bus or other interconnect, to coprocessor 2245. Coprocessor(s) 2245 accept and execute the received coprocessor instructions.

Referring now to Figure 23, shown is a block diagram of a first more specific exemplary system 2300 in accordance with an embodiment of the present disclosure. As shown in Figure 23, multiprocessor system 2300 is a point-to-point interconnect system, and includes a first processor 2370 and a second processor 2380 coupled via a point-to-point interconnect 2350. Each of processors 2370 and 2380 may be some version of the processor 2100. In one embodiment of the disclosure, processors 2370 and 2380 are respectively processors 2110 and 2115, while coprocessor 2338 is coprocessor 2145. In another embodiment, processors 2370 and 2380 are respectively processor 2110 coprocessor 2145.

Processors 2370 and 2380 are shown including integrated memory controller (IMC) units 2372 and 2382, respectively. Processor 2370 also includes as part of its bus controller units point-to-point (P-P) interfaces 2376 and 2378; similarly, second processor 2380 includes P-P interfaces 2386 and 2388. Processors 2370, 2380 may exchange information via a point-to-point (P-P) interface 2350 using P-P interface circuits 2378, 2388. As shown in Figure 23, IMCs 2372 and 2382 couple the processors to respective memories, namely a memory 2332 and a memory 2334, which may be portions of main memory locally attached to the respective processors.

Processors 2370, 2380 may each exchange information with a chipset 2390 via individual P-P interfaces 2352, 2354 using point to point interface circuits 2376, 2394, 2386, 2398. Chipset 2390 may optionally exchange information with the coprocessor 2338 via a high-performance interface 2320. In one embodiment, the coprocessor2338 is a special-purpose processor, such as, for example, a high-throughput MIC processor, a network or communication processor, compression engine, graphics processor, GPGPU, embedded processor, or the like.

A shared cache (not shown) may be included in either processor or outside of both processors, yet connected with the processors via P-P interconnect, such that either or both processors' local cache information may be stored in the shared cache if a processor is placed into a low power mode.

Chipset 2390 may be coupled to a first bus 2316 via an interface 2396. In one embodiment, first bus 2316 may be a Peripheral Component Interconnect (PCI) bus, or a bus such as a PCI Express bus or another third generation I/O interconnect bus, although the scope of the present disclosure is not so limited.

As shown in Figure 23, various I/O devices 2314 may be coupled to first bus 2316, along with a bus bridge 2318 which couples first bus 2316 to a second bus 2320. In one embodiment, one or more additional processor(s) 2315, such as coprocessors, high-throughput MIC processors, GPGPU's, accelerators (such as, e.g., graphics accelerators or digital signal processing (DSP) units), field programmable gate arrays, or any other processor, are coupled to first bus 2316. In one embodiment, second bus 2320 may be a low pin count (LPC) bus. Various devices may be coupled to a second bus 2320 including, for example, a keyboard and/or mouse 2322, communication devices 2327 and a storage unit 2328 such as a disk drive or other mass storage device which may include instructions/code and data 2330, in one embodiment. Further, an audio I/O 2324 may be coupled to the second bus 2320. Note that other architectures are possible. For example, instead of the point-to-point architecture of Figure 23, a system may implement a multi-drop bus or other such architecture.

Referring now to Figure 43, shown is a block diagram of a second more specific exemplary system 4300 in accordance with an embodiment of the present disclosure. Like elements in Figures 23 and 43 bear like reference numerals, and certain aspects of Figure 23 have been omitted from Figure 43 in order to avoid obscuring other aspects of Figure 43.

Figure 43 illustrates that the processors 2370, 2380 may include integrated memory and I/O control logic ("CL") 2372 and 2382, respectively. Thus, the CL 2372, 2382 include integrated memory controller units and include I/O control logic. Figure 43 illustrates that not only are the memories 2332, 2334 coupled to the CL 2372, 2382, but also that I/O devices 4314 are also coupled to the control logic 2372, 2382. Legacy I/O devices 4315 are coupled to the chipset 2390.

Referring now to Figure 25, shown is a block diagram of a SoC 2500 in accordance with an embodiment of the present disclosure. Similar elements in Figure 21 bear like reference numerals. Also, dashed lined boxes are optional features on more advanced SoCs. In Figure 25, an interconnect unit(s) 2502 is coupled to: an application processor 2510 which includes a set of one or more cores 202A-N and shared cache unit(s) 2106; a system agent unit 2110; a bus controller unit(s) 2116; an integrated memory controller unit(s) 2114; a set or one or more coprocessors 2520 which may include integrated graphics logic, an image processor, an audio processor, and a video processor; an static random access memory (SRAM) unit 2530; a direct memory access (DMA) unit 2532; and a display unit 2540 for coupling to one or more external displays. In one embodiment, the coprocessor(s) 2520 include a special-purpose processor, such as, for example, a network or communication processor, compression engine, GPGPU, a high-throughput MIC processor, embedded processor, or the like.

Embodiments (e.g., of the mechanisms) disclosed herein may be implemented in hardware, software, firmware, or a combination of such implementation approaches. Embodiments of the disclosure may be implemented as computer programs or program code executing on programmable systems comprising at least one processor, a storage system (including volatile and non-volatile memory and/or storage elements), at least one input device, and at least one output device.

Program code, such as code 2330 illustrated in Figure 23, may be applied to input instructions to perform the functions described herein and generate output information. The output information may be applied to one or more output devices, in known fashion. For purposes of this application, a processing system includes any system that has a processor, such as, for example; a digital signal processor (DSP), a microcontroller, an application specific integrated circuit (ASIC), or a microprocessor.

The program code may be implemented in a high level procedural or object oriented programming language to communicate with a processing system. The program code may also be implemented in assembly or machine language, if desired. In fact, the mechanisms described herein are not limited in scope to any particular programming language. In any case, the language may be a compiled or interpreted language.

One or more aspects of at least one embodiment may be implemented by representative instructions stored on a machine-readable medium which represents various logic within the processor, which when read by a machine causes the machine to fabricate logic to perform the techniques described herein. Such representations, known as "IP cores" may be stored on a tangible, machine readable medium and supplied to various customers or manufacturing facilities to load into the fabrication machines that actually make the logic or processor.

Such machine-readable storage media may include, without limitation, non-transitory, tangible arrangements of articles manufactured or formed by a machine or device, including storage media such as hard disks, any other type of disk including floppy disks, optical disks, compact disk read-only memories (CD-ROMs), compact disk rewritables (CD-RWs), and magneto-optical disks, semiconductor devices such as read-only memories (ROMs), random access memories (RAMs) such as dynamic random access memories (DRAMs), static random access memories (SRAMs), erasable programmable read-only memories (EPROMs), flash memories, electrically erasable programmable read-only memories (EEPROMs), phase change memory (PCM), magnetic or optical cards, or any other type of media suitable for storing electronic instructions.

Accordingly, embodiments of the disclosure also include non-transitory, tangible machine-readable media containing instructions or containing design data, such as Hardware Description Language (HDL), which defines structures, circuits, apparatuses, processors and/or system features described herein. Such embodiments may also be referred to as program products.

### Emulation (including binary translation, code morphing, etc.)

In some cases, an instruction converter may be used to convert an instruction from a source instruction set to a target instruction set. For example, the instruction converter may translate (e.g., using static binary translation, dynamic binary translation including dynamic compilation), morph, emulate, or otherwise convert an instruction to one or more other instructions to be processed by the core. The instruction converter may be implemented in software, hardware, firmware, or a combination thereof. The instruction converter may be on processor, off processor, or part on and part off processor.

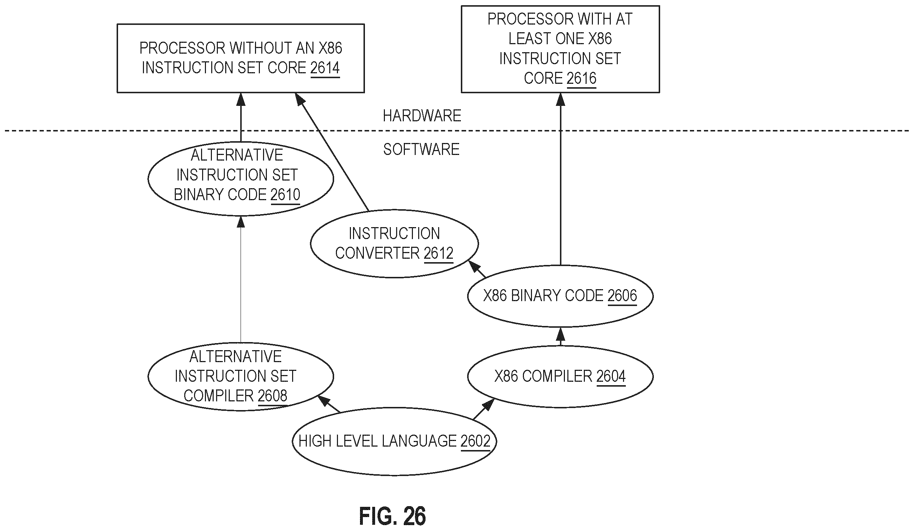

Figure 26 is a block diagram contrasting the use of a software instruction converter to convert binary instructions in a source instruction set to binary instructions in a target instruction set according to embodiments of the disclosure. In the illustrated embodiment, the instruction converter is a software instruction converter, although alternatively the instruction converter may be implemented in software, firmware, hardware, or various combinations thereof. Figure 26 shows a program in a high level language 2602 may be compiled using an x86 compiler 2604 to generate x86 binary code 2606 that may be natively executed by a processor with at least one x86 instruction set core 2616. The processor with at least one x86 instruction set core 2616 represents any processor that can perform substantially the same functions as an Intel@ processor with at least one x86 instruction set core by compatibly executing or otherwise processing (1) a substantial portion of the instruction set of the Intel@ x86 instruction set core or (2) object code versions of applications or other software targeted to run on an Intel@ processor with at least one x86 instruction set core, in order to achieve substantially the same result as an Intel@ processor with at least one x86 instruction set core. The x86 compiler 2604 represents a compiler that is operable to generate x86 binary code 2606 (e.g., object code) that can, with or without additional linkage processing, be executed on the processor with at least one x86 instruction set core 2616. Similarly, Figure 26 shows the program in the high level language 2602 may be compiled using an alternative instruction set compiler 2608 to generate alternative instruction set binary code 2610 that may be natively executed by a processor without at least one x86 instruction set core 2614 (e.g., a processor with cores that execute the MIPS instruction set of MIPS Technologies of Sunnyvale, CA and/or that execute the ARM instruction set of ARM Holdings of Sunnyvale, CA). The instruction converter 2612 is used to convert the x86 binary code 2606 into code that may be natively executed by the processor without an x86 instruction set core 2614. This converted code is not likely to be the same as the alternative instruction set binary code 2610 because an instruction converter capable of this is difficult to make; however, the converted code will accomplish the general operation and be made up of instructions from the alternative instruction set. Thus, the instruction converter 2612 represents software, firmware, hardware, or a combination thereof that, through emulation, simulation or any other process, allows a processor or other electronic device that does not have an x86 instruction set processor or core to execute the x86 binary code 2606.

Certain embodiments provide for the cohesive flow of individual dies in wafers into packaged modular die products. Additionally, these embodiments provide for modularity and extensibility of tiling several modular dies (e.g., heterogeneous modular dies) and further provide for interconnections between the dies over an interconnect mesh or fabric.

Different embodiments achieve connectivity between these dies in different ways. For example, in 2.5D packaging solutions, a silicon interposer and through-substrate vias (TSVs) connect dies at silicon interconnect speed in a minimal footprint. In another example, a bridge die may be used. For example, an Embedded Multi-Die Interconnect Bridge (EMIB) is a silicon bridge embedded under the edges of two interconnecting dies facilitates electrical coupling between them. In a three-dimensional (3D) architecture, the dies are stacked one above the other, creating a smaller footprint overall. Typically, the electrical connectivity and mechanical coupling in such 3D architecture is achieved using TSVs and high pitch solder-based bumps (e.g., C4 interconnections). The EMIB and the 3D stacked architecture may also be combined using an omni-directional interconnect (ODI), which allows for top-packaged chips to communicate with other chips horizontally using EMIB and vertically, using Through-Mold Vias (TMVs) which are typically larger than TSVs.

However, as the number of individual IC dies integrated onto a single microprocessor or other such system-in-package increases, the footprint available on a fixed-size package substrate for interconnecting these IC dies becomes challenging. To help alleviate the footprint challenge, IC dies may be sized to be uniform and arranged in a grid pattern in a tiled compute architecture. This tiling allows adding more core complex IC dies or replacing the input/output (IO) dies to fit different products. As used herein, the terms "core complex," and "core" are used interchangeably to refer to a circuit comprising a reusable unit of logic, cell, or IC layout design with a particular functionality and defined interface, which serves as a building block in an IC chip design. For example, cores may comprise a set of memory registers, arithmetic logic unit (ALU), power converters, high-speed I/O interfaces, peripherals, programmable microprocessors, micro-controllers, digital signal processors, analog-digital mixed-signal processing blocks, configurable computing architectures, etc. A smaller core (e.g., computing core) may be combined with other smaller cores (e.g., memory) to form a larger core. For example, a core may comprise a computing core coupled to IO circuits that bring data into and out of the computing core, a power delivery circuit to deliver power to the computing core and aggregated or disaggregated memory banks that function as cache for the computing core. A plurality of such cores may be referred to as a core complex, although they may also be simply called cores. As computing cores typically require additional components to create a fully functional chip or a SOC, these complementary components are assumed to be inherent, either coupled directly to the cores in question or by way of other cores or circuit blocks (e.g., portions, i.e., "blocks" of circuits), in the microelectronic assembly of the various embodiments disclosed herein.

On the electrical and logic protocol side, this is accommodated through standardizing the die-to-die interfaces to accommodate connecting different dies together. In some scenarios, e.g., when moving core or IO dies to different process nodes or different manufacturers, the die sizes end up becoming a bit larger or smaller. This can be accommodated in standard organic packages where the die-to-die routing density is not very high and having matching die edge sizes is not a major requirement. However, this is very challenging to accommodate in 3D ICs with fixed (e.g., silicon) interposer or EMIB sizes/widths and tight channel specifications.

Embodiments (e.g., of the mechanisms) disclosed herein may be implemented in hardware, software, firmware, or a combination of such implementation approaches. Embodiments of the disclosure may be implemented as computer programs or program code executing on programmable systems comprising at least one processor, a storage system (including volatile and non-volatile memory and/or storage elements), at least one input device, and at least one output device.

Program code may be applied to input instructions to perform the functions described herein and generate output information. The output information may be applied to one or more output devices, in known fashion. For purposes of this application, a processing system includes any system that has a processor, such as, for example; a digital signal processor (DSP), a microcontroller, an application specific integrated circuit (ASIC), or a microprocessor.

The program code may be implemented in a high level procedural or object oriented programming language to communicate with a processing system. The program code may also be implemented in assembly or machine language, if desired. In fact, the mechanisms described herein are not limited in scope to any particular programming language. In any case, the language may be a compiled or interpreted language.

One or more aspects of at least one embodiment may be implemented by representative instructions stored on a machine-readable medium which represents various logic within the processor, which when read by a machine causes the machine to fabricate logic to perform the techniques described herein. Such representations, known as "IP cores" may be stored on a tangible, machine readable medium and supplied to various customers or manufacturing facilities to load into the fabrication machines that actually make the logic or processor.

The following are example implementations of different embodiments of the invention
Example 1. A processor, comprising: a plurality of dies; a first die of the plurality of dies coupled over a first inter-die link to a second die, the first die comprising: a first one or more message control registers to store message fields; message compression circuitry to compress a message transmitted over the first inter-die link to the second die, the message compression circuitry to replace a message field in the message with an indication of a storage location of the message field in the first one or more message control registers; the second die comprising: a second one or more message control registers to store the message fields; message decompression circuitry to decompress the message received over the first inter-die link from the first die, the message decompression circuitry to identify the storage location of the message field in the second one or more message control registers based on the indication and to insert the message field in the message.
Example 2. The processor of example 1, wherein the message fields to be stored in the first one or more message control registers and the second one or more message control registers comprise message fields which are duplicated in multiple messages of a transaction.
Example 3. The processor of examples 1 or 2 wherein the message fields comprise packet header fields.
Example 4. The processor of any of examples 1-3 wherein the indication includes a message control register identifier (ID) to identify a particular message control register of the first one or more message control registers and the second one or more message control registers.
Example 5. The processor of any of examples 1-4 wherein the indication further includes a plurality of bits to identify a location in the particular message control register.
Example 6. The processor of any of examples 1-5 wherein the first die further comprises: a plurality of cores to execute instructions; a memory controller to couple to a system memory; a first on-die fabric coupled to the plurality of cores and the memory controller; and a first die-to-die interface coupled to the first on-die fabric and the first inter-die link, the first die-to-die interface including the message compression circuitry.
Example 7. The processor of any of examples 1-6 wherein the message decompression circuitry comprises first message decompression circuitry and the message comprises a first message, the first die-to-die interface further comprising second message decompression circuitry to decompress a second message received over the first inter-die link from the second die.
Example 8. The processor of any of examples 1-7 wherein the indication comprises a first indication and wherein the second message comprises a second indication, the second message decompression circuitry to identify a message control register of the first one or more message control registers based on the second indication.
Example 9. The processor of any of examples 1-8 wherein the message field comprises a first message field, wherein the second message decompression circuitry is to identify a second message field in the message control register of the first one or more message control registers based on the second indication.
Example 10. A method, comprising: storing message fields in a first one or more message control registers of a first die of a plurality of dies; storing the message fields in a second one or more message control registers of a second die of the plurality of dies, wherein the first die is coupled to the second die over an inter-die link; compressing a message transmitted over a first inter-die link from the first die to the second die, wherein compressing includes replacing a message field in the message with an indication of a storage location of the message field in the first one or more message control registers and the second one or more message control registers; decompressing the message received by the second die over the first inter-die link, wherein decompressing includes identifying the storage location of the message field in the second one or more message control registers based on the indication and inserting the message field in the message.
Example 11. The method of any of examples 1-10, wherein the message fields to be stored in the first one or more message control registers and the second one or more message control registers comprise message fields which are duplicated in multiple messages of a transaction.
Example 12. The method of any of examples 1-11 wherein the message fields comprise packet header fields.
Example 13. The method of any of examples 1-12 wherein the indication includes a message control register identifier (ID) to identify a particular message control register of the first one or more message control registers and the second one or more message control registers.
Example 14. The method of any of examples 1-13 wherein the indication further includes a plurality of bits to identify a location in the particular message control register.
Example 15. The method of any of examples 1-14 wherein the message comprises a first message, the method further comprising: decompressing a second message received over the first inter-die link from the second die.
Example 16. The method of any of examples 1-15 wherein the indication comprises a first indication and wherein the second message comprises a second indication, the method further comprising: identifying a message control register of the first one or more message control registers based on the second indication.
Example 17. The method of any of examples 1-16 wherein the message field comprises a first message field, the method further comprising: identifying a second message field in the message control register of the first one or more message control registers based on the second indication.
Example 18. A machine-readable medium having program code stored thereon which, when executed by a machine, causes the machine to perform operations, comprising: storing message fields in a first one or more message control registers of a first die of a plurality of dies; storing the message fields in a second one or more message control registers of a second die of the plurality of dies, wherein the first die is coupled to the second die over an inter-die link; compressing a message transmitted over a first inter-die link from the first die to the second die, wherein compressing includes replacing a message field in the message with an indication of a storage location of the message field in the first one or more message control registers and the second one or more message control registers; decompressing the message received by the second die over the first inter-die link, wherein decompressing includes identifying the storage location of the message field in the second one or more message control registers based on the indication and inserting the message field in the message.
Example 19. The machine-readable medium of example 18, wherein the message fields to be stored in the first one or more message control registers and the second one or more message control registers comprise message fields which are duplicated in multiple messages of a transaction.
Example 20. The machine-readable medium of example 18 or 19 wherein the message fields comprise packet header fields.
Example 21. The machine-readable medium of any of examples 18-20 wherein the indication includes a message control register identifier (ID) to identify a particular message control register of the first one or more message control registers and the second one or more message control registers.
Example 22. The machine-readable medium of any of examples 18-21 wherein the indication further includes a plurality of bits to identify a location in the particular message control register.
23. The machine-readable medium of any of examples 18-22 wherein the message comprises a first message, the machine-readable medium further comprising program code to cause the machine to perform an operation of: decompressing a second message received over the first inter-die link from the second die.
Example 24. The machine-readable medium of any of examples 18-23 wherein the indication comprises a first indication and wherein the second message comprises a second indication, the machine-readable medium further comprising program code to cause the machine to perform an operation of: identifying a message control register of the first one or more message control registers based on the second indication.
Example 25. The machine-readable medium of any of examples 18-24 wherein the message field comprises a first message field, the machine-readable medium further comprising program code to cause the machine to perform an operation of: identifying a second message field in the message control register of the first one or more message control registers based on the second indication.

Such machine-readable storage media may include, without limitation, non-transitory, tangible arrangements of articles manufactured or formed by a machine or device, including storage media such as hard disks, any other type of disk including floppy disks, optical disks, compact disk read-only memories (CD-ROMs), compact disk rewritables (CD-RWs), and magneto-optical disks, semiconductor devices such as read-only memories (ROMs), random access memories (RAMs) such as dynamic random access memories (DRAMs), static random access memories (SRAMs), erasable programmable read-only memories (EPROMs), flash memories, electrically erasable programmable read-only memories (EEPROMs), phase change memory (PCM), magnetic or optical cards, or any other type of media suitable for storing electronic instructions.

Accordingly, embodiments of the disclosure also include non-transitory, tangible machine-readable media containing instructions or containing design data, such as Hardware Description Language (HDL), which defines structures, circuits, apparatuses, processors and/or system features described herein. Such embodiments may also be referred to as program products.

## Claims

1. A processor, comprising:
a plurality of dies;
a first die of the plurality of dies coupled over a first inter-die link to a second die of the plurality of dies,
the first die comprising:
a first one or more message control registers to store message fields; and
a first message compression circuitry to compress a message transmitted over the first inter-die link to the second die, the first message compression circuitry to replace a message field in the message with an indication of a storage location of the message field in the first one or more message control registers;
the second die comprising:
a second one or more message control registers to store the message fields; and
a first message decompression circuitry to decompress the message received over the first inter-die link from the first die, the first message decompression circuitry to identify the storage location of the message field in the second one or more message control registers based on the indication and to insert the message field in the message.

2. The processor of claim 1, wherein the message fields to be stored in the first one or more message control registers and the second one or more message control registers comprise message fields which are duplicated in multiple messages of a transaction.

3. The processor of claim 2 wherein the message fields comprise packet header fields.

4. The processor of any of claims 1 to 3 wherein the indication includes a message control register identifier (ID) to identify a particular message control register of the first one or more message control registers and the second one or more message control registers.

5. The processor of claim 4 wherein the indication further includes a plurality of bits to identify a location in the particular message control register.

6. The processor of any of claims 1 to 5 wherein the first die further comprises:
a plurality of cores to execute instructions;
a memory controller to couple to a system memory;
a first on-die fabric coupled to the plurality of cores and the memory controller; and
a first die-to-die interface coupled to the first on-die fabric and the first inter-die link, the first die-to-die interface including the first message compression circuitry.

7. The processor of claim 6 wherein the message comprises a first message, the first die-to-die interface further comprising second message decompression circuitry to decompress a second message received over the first inter-die link from the second die.

8. The processor of claim 7 wherein the indication comprises a first indication and wherein the second message comprises a second indication, the second message decompression circuitry to identify a message control register of the first one or more message control registers based on the second indication.

9. The processor of claim 8 wherein the message field comprises a first message field, wherein the second message decompression circuitry is to identify a second message field in the message control register of the first one or more message control registers based on the second indication.

10. A method, comprising:
storing message fields in a first one or more message control registers of a first die of a plurality of dies;
storing the message fields in a second one or more message control registers of a second die of the plurality of dies, wherein the first die is coupled to the second die over an inter-die link;
compressing a message transmitted over a first inter-die link from the first die to the second die, wherein compressing includes replacing a message field in the message with an indication of a storage location of the message field in the first one or more message control registers and the second one or more message control registers; and
decompressing the message received by the second die over the first inter-die link, wherein decompressing includes identifying the storage location of the message field in the second one or more message control registers based on the indication and inserting the message field in the message.

11. The method of claim 10, wherein the message fields to be stored in the first one or more message control registers and the second one or more message control registers comprise message fields which are duplicated in multiple messages of a transaction.

12. The method of claim 11 wherein the message fields comprise packet header fields.

13. The method of any of claims 10 to 12 wherein the indication includes a message control register identifier, ID, to identify a particular message control register of the first one or more message control registers and the second one or more message control registers.

14. The method of claim 13 wherein the indication further includes a plurality of bits to identify a location in the particular message control register.

15. The method of any of claims 10 to 14 wherein the message comprises a first message, the method further comprising: decompressing a second message received over the first inter-die link from the second die.
